(19) Europäisches Patentamt
European Patent Office
Office européen des brevets

(11) **EP 4 633 187 A1**

(12) **EUROPEAN PATENT APPLICATION**
published in accordance with Art. 153(4) EPC

(43) Date of publication:
**15.10.2025  Bulletin 2025/42**

(21) Application number: **23900536.6**

(22) Date of filing: **29.11.2023**

(51) International Patent Classification (IPC):
**H04N 25/77** *(2023.01)*

(52) Cooperative Patent Classification (CPC):
**H04N 25/77**

(86) International application number:
**PCT/JP2023/042647**

(87) International publication number:
**WO 2024/122420 (13.06.2024 Gazette 2024/24)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **07.12.2022  JP 2022195914**

(71) Applicant: **Sony Semiconductor Solutions Corporation**
**Atsugi-shi, Kanagawa 243-0014 (JP)**

(72) Inventors:
• **TASHIRO Kosuke**
**Atsugi-shi, Kanagawa 243-0014 (JP)**
• **UMEDA Kengo**
**Atsugi-shi, Kanagawa 243-0014 (JP)**
• **NAGANOKAWA Haruhisa**
**Atsugi-shi, Kanagawa 243-0014 (JP)**

(74) Representative: **MFG Patentanwälte Meyer-Wildhagen Meggle-Freund Gerhard PartG mbB**
**Amalienstraße 62**
**80799 München (DE)**

(54) **PHOTODETECTOR ELEMENT**

(57)    AD conversion can be performed at high speed, and image quality of a captured image is improved.

A light detection element includes: a first attenuation circuit that attenuates an input signal at any of a plurality of attenuation rates according to a signal level and outputs an output signal; a second attenuation circuit that attenuates a reference signal at an attenuation rate according to a control signal and outputs an output signal; a first comparator that compares the output signal of the first attenuation circuit with the output signal of the second attenuation circuit; and a first counter that generates a digital signal according to the input signal on the basis of a comparison result of the first comparator.

*FIG. 5*

EP 4 633 187 A1

**Description**

TECHNICAL FIELD

The present disclosure relates to a light detection element.

BACKGROUND ART

In a light detection element such as an image sensor, a column ADC method in which an analog to digital converter (ADC) is disposed for each pixel column is widely used. In the column ADC method, for example, a single-slope ADC including a comparator and a counter is disposed for each pixel column. The comparator compares a pixel signal on a corresponding vertical signal line with a reference signal whose signal level changes. The counter performs a measurement operation during a period until the comparator detects matching between the pixel signal and the reference signal. A measurement value of the counter at the time point when the pixel signal and the reference signal match becomes a digital signal obtained by analog-digital conversion (Hereinafter, AD conversion) of the pixel signal.

The signal level of the pixel signal changes depending on the illuminance of light incident on the pixel, and the higher the illuminance, the lower the signal level of the pixel signal. When the signal level of the pixel signal decreases, a time period until matching between the pixel signal and the reference signal is detected by the comparator increases, and the speed of the AD conversion decreases.

Therefore, in Patent Document 1, in a case where the illuminance of the light incident on the pixel is high, the pixel signal is attenuated and then compared with the reference signal, so that the timing that matches the reference signal is advanced, thereby improving the speed of the AD conversion.

CITATION LIST

PATENT DOCUMENT

Patent Document 1: Japanese Patent Application Laid-Open No. 2019-57873

SUMMARY OF THE INVENTION

PROBLEMS TO BE SOLVED BY THE INVENTION

In the case of Patent Document 1, by comparing the pixel signal with the reference signal after the pixel signal is attenuated, it is possible to advance the timing at which the pixel signal matches the reference signal.

Since the reference signal is generated by a digital to analog converter (DAC) and supplied to each ADC via wiring shared by a plurality of ADCs, noise is likely to be superimposed on the reference signal. For this reason, there is a possibility that horizontal streak noise is superimposed on the AD-converted digital pixel signal.

Therefore, the present disclosure provides a light detection element capable of performing AD conversion at high speed and improving image quality of a captured image.

SOLUTIONS TO PROBLEMS

In order to solve the above problem, according to the present disclosure, there is provided a light detection element including:

a first attenuation circuit that attenuates an input signal at any of a plurality of attenuation rates according to a signal level and outputs an output signal;
a second attenuation circuit that attenuates a reference signal at an attenuation rate according to a control signal and outputs an output signal;
a first comparator that compares the output signal of the first attenuation circuit with the output signal of the second attenuation circuit; and
a first counter that generates a digital signal according to the input signal on the basis of a comparison result of the first comparator.

The second attenuation circuit may attenuate the reference signal at an attenuation rate according to the control signal and output an output signal before the first comparator starts a comparison operation.

The first attenuation circuit may determine an attenuation rate according to a signal level of the input signal after an attenuation rate of the second attenuation circuit is determined.

A reference signal line that transmits the reference signal, and

a source follower circuit connected to the reference signal line, may be further included,
the second attenuation circuit may include:

a first switch and a first capacitor connected in series between an output node of the source follower circuit and a first input terminal of the first comparator; and
a second switch and a second capacitor connected in series between the output node of the source follower circuit and the first input terminal of the first comparator, and
the first switch and the second switch may be switch-controlled by the control signal.

The second attenuation circuit may performs switching control of the first switch and the second switch on the basis of the control signal such that the reference signal is attenuated at an attenuation rate according to a capacitance ratio between the first capacitor and the second capacitor.

A logic circuit that generates the control signal for performing switching control of the first switch and the second switch according to illuminance of light incident on a target pixel may be further included.

A third attenuation circuit that attenuates an input signal at any of a plurality of attenuation rates according to a signal level and outputs an output signal,

a second comparator that compares the output signal of the third attenuation circuit with a reference signal having a fixed signal level, and
a second counter that generates a digital signal according to the input signal on the basis of a comparison result of the second comparator may be further included.

A plurality of first analog-digital converters arranged in a predetermined direction, each of the first analog-digital converters including the first attenuation circuit, the second attenuation circuit, the first comparator, and the first counter, and

a plurality of second analog-digital converters arranged in the predetermined direction, each of the second analog-digital converters including the third attenuation circuit, the second comparator, and the second counter, may be further included, and
one or more of the second analog-digital converters may be arranged between the plurality of first analog-digital converters.

A third attenuation circuit that attenuates an input signal at any of a plurality of attenuation rates according to a signal level and outputs an output signal,

a fourth attenuation circuit that attenuates a reference signal at an attenuation rate according to the control signal and outputs an output signal, and
a second comparator that compares the output signal of the third attenuation circuit with the output signal of the fourth attenuation circuit may be further included, and
the second attenuation circuit and the fourth attenuation circuit may have different attenuation rates for the reference signal.

The input signal attenuated by the first attenuation circuit and the input signal attenuated by the third attenuation circuit may include pixel signals photoelectrically converted by photoelectric conversion elements having sizes or numbers different from each other.

A plurality of analog-digital converters arranged in a predetermined direction, each of the analog-digital converters including the first attenuation circuit, the second attenuation circuit, the first comparator, and the first counter may be further included, and
a plurality of the second attenuation circuits in the plurality of analog-digital converters may individually set an attenuation rate of the reference signal.

Furthermore, according to the present disclosure, there is provided a light detection element including:

a first attenuation circuit that attenuates an input signal at any of three or more attenuation rates according to a signal level and outputs an output signal;
a first comparator that compares the output signal of the first attenuation circuit with a reference signal; and
a first counter that generates a digital signal according to the input signal on the basis of a comparison result of the first comparator.

The first attenuation circuit may attenuate and output the input signal at any of three or more attenuation rates according to a signal level on the basis of whether or not the signal level of the input signal exceeds a predetermined threshold and a control signal.

The first attenuation circuit may attenuate and output at any of two or more attenuation rates according to the signal level of the input signal on the basis of the control signal in a case where the signal level of the input signal exceeds the predetermined threshold, and may attenuate and output at any of two or more attenuation rates according to the signal level of the input signal on the basis of the control signal in a case where the signal level of the input signal is less than or equal to the predetermined threshold.

A logic circuit that generates the control signal according to illuminance of light incident on a target pixel may be further included.

The input signal may include a reset signal upon photoelectric conversion or a photoelectrically converted pixel signal,

the light detection element may further include a determination section that determines whether or not a signal level of the input signal exceeds the predetermined threshold on the basis of a result of comparison between the pixel signal and the reference signal corresponding to the pixel signal after the first comparator compares the reset signal with the reference signal corresponding to the reset signal, and
the first attenuation circuit may select an attenuation rate on the basis of a determination result of the determination section.

The determination section may compare the pixel signal with the reference signal without attenuating the pixel signal, or may compare the pixel signal with the reference signal in a state where the pixel signal is attenuated at an attenuation rate according to the control signal.

A second attenuation circuit that attenuates an input signal at any of three or more attenuation rates according to a signal level and outputs an output signal,

> a second comparator that compares the output signal of the second attenuation circuit with a reference signal having a fixed signal level, and
> a second counter that generates a digital signal according to the input signal on the basis of a comparison result of the second comparator may be further included, and
> the input signal attenuated by the first attenuation circuit and the input signal attenuated by the second attenuation circuit may include pixel signals photoelectrically converted by photoelectric conversion elements having sizes or numbers different from each other.

Furthermore, according to the present disclosure, there is provided a light detection element including:

> a plurality of comparators that compares respective separate input signals with reference signals; and
> a plurality of counters that generates digital signals according to corresponding input signals on the basis of comparison results of the plurality of comparators,
> in which an attenuation rate of at least one of each of the input signals and each of the reference signals input to each of the plurality of comparators is individually set for each of the plurality of comparators.

A plurality of first attenuation circuits and a plurality of second attenuation circuits may be provided corresponding to the plurality of comparators,

> each of the plurality of first attenuation circuits may attenuate each of the corresponding input signals at any of three or more attenuation rates according to a signal level and output an output signal,
> each of the plurality of second attenuation circuits may attenuate each of the reference signals at an attenuation rate according to a control signal and output an output signal, and
> each of the plurality of comparators may compare the output signal of the corresponding first attenuation circuit with the output signal of the corresponding second attenuation circuit.

BRIEF DESCRIPTION OF DRAWINGS

> Fig. 1 is a block diagram illustrating a schematic configuration of an imaging device including a light detection element according to the present disclosure.
> Fig. 2 is a block diagram illustrating a schematic configuration of a light detection element according to the present disclosure.
Fig. 3 is a circuit diagram of each pixel in a pixel array section.
Fig. 4 is a block diagram illustrating an example of an internal configuration of a load current supply section and a column ADC.
Fig. 5 is a block diagram illustrating an internal configuration of a column ADC according to a first embodiment.
Fig. 6 is a block diagram illustrating a detailed configuration of one ADC in the column ADC.
Fig. 7 is a diagram of signal waveforms inside the ADC.
Fig. 8 is a flowchart illustrating a processing operation of a light detection element according to the first embodiment.
Fig. 9A is a signal waveform diagram of a pixel signal on a vertical signal line.
Fig. 9B is a signal waveform diagram of a pixel signal attenuated by a VSL attenuation circuit.

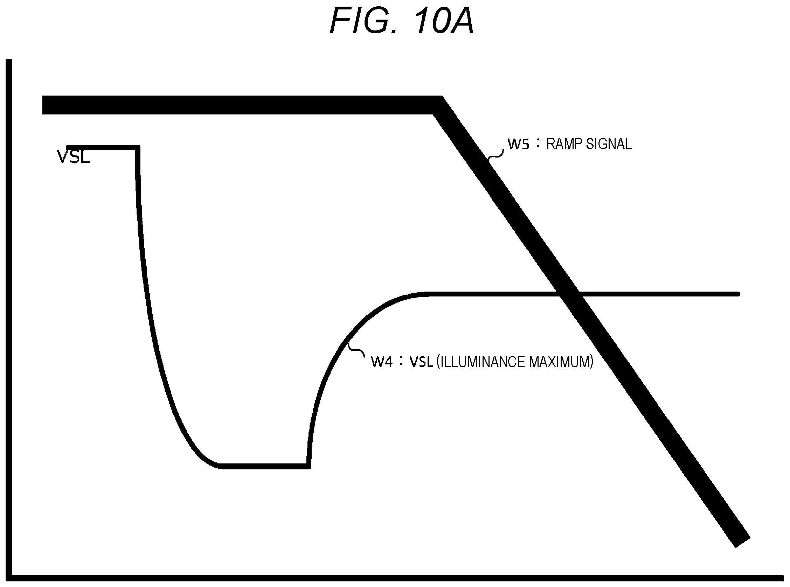

Fig. 10A is a signal waveform diagram of a ramp signal before attenuation.

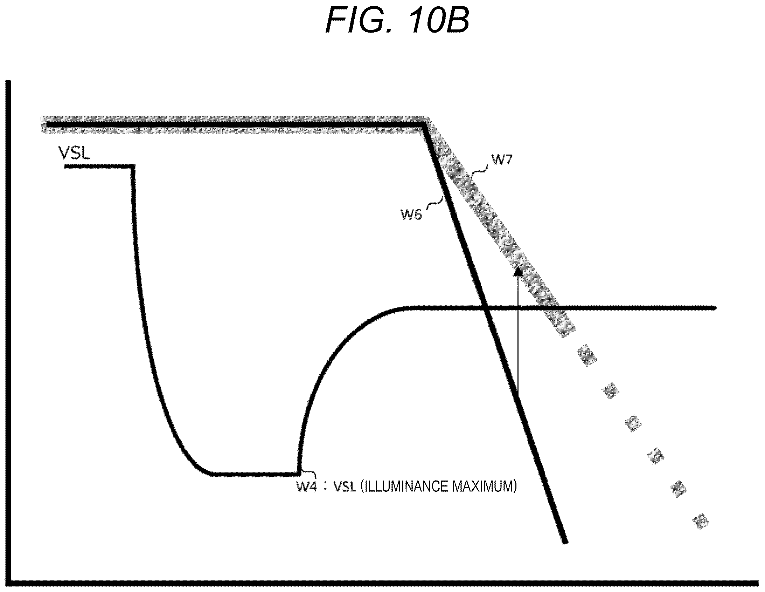

Fig. 10B is a diagram illustrating a signal waveform in which the signal waveform of the ramp signal of Fig. 10A is steepened by a ramp generation circuit and a signal waveform in which the signal waveform is attenuated by a ramp attenuation circuit.
Fig. 11A is a diagram schematically illustrating a state in which noise is superimposed on a ramp signal generated by the ramp generation circuit and transmitted through a ramp wiring.
Fig. 11B is a diagram illustrating an example in which the signal waveform of the ramp signal is changed in the ramp generation circuit.
Fig. 12A is a signal waveform diagram of the ramp signal supplied from the ramp generation circuit to the ramp wiring similarly to Fig. 12A.
Fig. 12B is a signal waveform diagram of a ramp signal obtained by attenuating the ramp signal of Fig. 13A with the ramp attenuation circuit.
Fig. 13 is a diagram illustrating horizontal streak noise appearing in a captured image.
Fig. 14 is a block diagram illustrating a schematic configuration of a column ADC included in a light detection element according to a second embodiment.
Fig. 15 is a block diagram illustrating a schematic configuration of a column ADC included in a light detection element according to a third embodiment.
Fig. 16A is a block diagram in a case where two ADCs are connected to one vertical signal line.
Fig. 16B is a signal waveform diagram of a ramp signal and a pixel signal input to a comparator in the ADC of Fig. 17A.
Fig. 17A is a block diagram of two ADCs that perform AD conversion on pixel signals from two types of pixels having different pixel sizes.

Fig. 17B is a signal waveform diagram of a ramp signal and a pixel signal input to a comparator in the ADC of Fig. 18A.

Fig. 18A is a block diagram illustrating an ADC for a normal pixel and an ADC for an image plane phase difference pixel.

Fig. 18B is a signal waveform diagram of a ramp signal and a pixel signal input to a comparator in the ADC of Fig. 19A.

Fig. 19 is a block diagram illustrating a schematic configuration of a light detection element according to a fourth embodiment.

Fig. 20 is a block diagram illustrating an internal configuration of a column ADC according to the fourth embodiment.

Fig. 21 is a signal waveform diagram of a pixel signal and a ramp signal attenuated by the VSL attenuation circuit of Fig. 21.

Fig. 22 is a signal waveform diagram illustrating a modification of Fig. 22.

Fig. 23 is a block diagram illustrating a schematic configuration of a column ADC included in a light detection element according to a fifth embodiment.

Fig. 24 is a block diagram of a column ADC illustrating a first specific example of the fifth embodiment.

Fig. 25 is a block diagram of a column ADC illustrating a second specific example of the fifth embodiment.

Fig. 26 is a block diagram illustrating a schematic configuration of a light detection element according to a sixth embodiment.

Fig. 27 is a block diagram illustrating an internal configuration of a column ADC according to the sixth embodiment.

Fig. 28 is a block diagram illustrating a schematic configuration of a column ADC corresponding to binning processing.

Fig. 29 is a block diagram illustrating a schematic configuration of a column ADC included in a light detection element according to a seventh embodiment.

Fig. 30 is a block diagram of a column ADC according to a first specific example of the seventh embodiment.

Fig. 31 is a block diagram of a column ADC according to a second specific example of the seventh embodiment.

Fig. 32 is a block diagram of a column ADC according to a third specific example of the seventh embodiment.

Fig. 33 is a block diagram illustrating an example of a schematic configuration of a vehicle control system.

Fig. 34 is an explanatory diagram illustrating an example of installation positions of an outside-vehicle information detecting section and an imaging section.

MODE FOR CARRYING OUT THE INVENTION

Hereinafter, embodiments of a light detection element will be described with reference to the drawings. In the following, main configuration parts of the light detection element will be described, but the light detection element may have configuration parts and functions that are not illustrated or described. The following description is not intended to exclude configuration parts and functions that are not illustrated or described.

<First embodiment>

(Schematic description of imaging device)

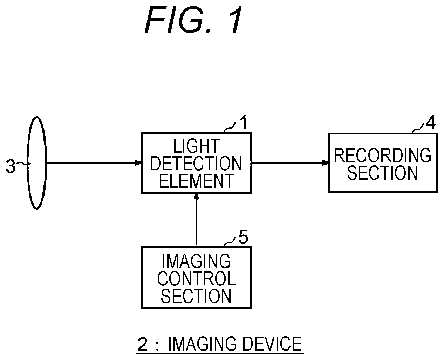

Fig. 1 is a block diagram illustrating a schematic configuration of an imaging device 2 including a light detection element 1 according to the present disclosure. The imaging device 2 of Fig. 1 includes an imaging lens 3, the light detection element 1, a recording section 4, and an imaging control section 5.

The light detection element 1 images a subject and generates image data. The light detection element 1 may be referred to as a solid-state imaging element or an image sensor. The light detection element 1 includes a plurality of pixels arranged in a one-dimensional direction or a two-dimensional direction, and each pixel includes a photoelectric conversion element. Each photoelectric conversion element is an element that photoelectrically converts light from a subject, and is, for example, a photodiode.

The imaging lens 3 condenses light and guides the light to the light detection element 1. The imaging control section 5 controls the light detection element 1. For example, the imaging control section 5 controls timing at which each pixel of the light detection element 1 performs exposure, transfer, and initialization.

The recording section 4 records image data captured by the light detection element 1. The recording section 4 may be detachable. The recording section 4 is not necessarily provided in the imaging device 2. For example, the image data may be recorded in the recording section 4 provided separately from the imaging device 2 via a wired or wireless communication interface provided in the imaging device 2.

(Schematic description of light detection element 1)

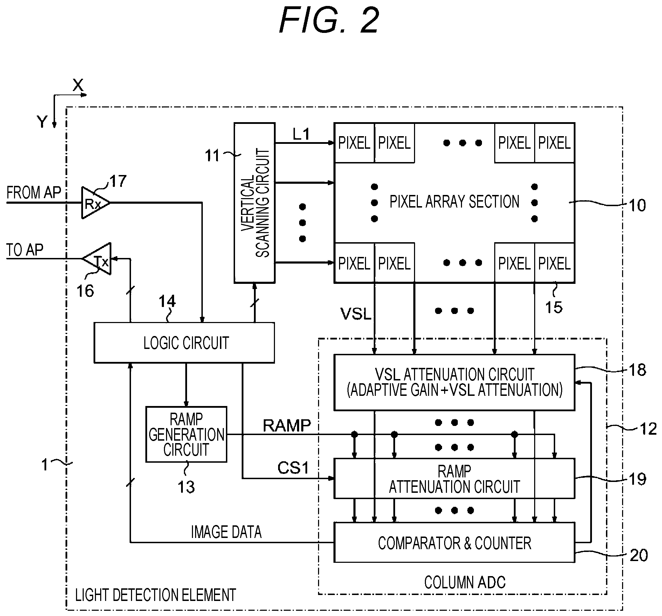

Fig. 2 is a block diagram illustrating a schematic configuration of the light detection element 1 according to the present disclosure. The light detection element 1 of Fig. 2 includes a pixel array section 10, a vertical scanning circuit 11, a column ADC 12, a ramp generation circuit 13, and a logic circuit 14. Note that Fig. 2 illustrates main configuration parts of the light detection element 1 according to the first embodiment, and the light detection element 1 may include configuration parts other than those illustrated in Fig. 2.

The pixel array section 10 includes a plurality of pixels 15 arranged in a two-dimensional direction (first direction X and second direction Y). An internal configuration of each of the pixels 15 will be described later. In the present specification, the first direction X is referred to as a horizontal direction or a row direction, and the second direction Y is referred to as a vertical direction or a column direction. Furthermore, in the present specification, a group of pixels aligned in one row in the first direction X is referred to as a pixel row, and a group of pixels aligned in one column in the second direction Y is referred to as a pixel column.

Each pixel row of the pixel array section 10 is connected to a corresponding row selection line (also referred to as a row scanning line) L1. A plurality of the row selection lines L1 corresponding to the plurality of pixel rows is connected to the vertical scanning circuit 11. The vertical scanning circuit 11 sequentially drives the plurality of row selection lines L1 to select the corresponding pixel row.

Each pixel column of the pixel array section 10 is connected to the corresponding vertical signal line VSL. The plurality of vertical signal lines VSL corresponding to the plurality of pixel columns is connected to the column ADC 12.

The ramp generation circuit 13 generates a ramp signal. The ramp signal is also referred to as a reference signal. The ramp generation circuit 13 can include a DAC. As will be described later, the ramp signal is a triangular or sawtooth signal whose signal level changes with time. The ramp signal includes a ramp waveform for comparison with the reset level signal (Hereinafter, it may be referred to as a P-phase signal.) and a ramp waveform for comparison with the photoelectrically converted pixel signal (Hereinafter, it may be referred to as a D-phase signal.). The ramp signal generated by the ramp generation circuit 13 is supplied to the column ADC 12 via the ramp wiring RAMP.

The ramp generation circuit 13 can control a slope of the ramp signal on the basis of an instruction from the logic circuit 14. The slope is a change amount of the signal level per unit time of the ramp signal. For example, in a case where the illuminance of the light incident on the pixel 15 is higher than the predetermined reference illuminance, the slope is made larger than that in a case where the illuminance is lower than or equal to the reference illuminance. Therefore, even in a case where the signal level of the pixel signal is low, the time when the pixel signal intersects with the ramp signal can be shortened, and the AD conversion speed can be improved.

The column ADC 12 includes a plurality of ADCs that performs AD conversion of a pixel signal for each vertical signal line VSL. The plurality of ADCs is arranged along the first direction X (row direction). The column ADC 12 includes a VSL attenuation circuit (first attenuation circuit) 18, a ramp attenuation circuit (second attenuation circuit) 19, and a comparator & counter 20. In practice, the VSL attenuation circuit 18 and the ramp attenuation circuit are provided for each of the plurality of ADCs, but in Fig. 2, one VSL attenuation circuit 18 and one ramp attenuation circuit 19 are illustrated for simplicity.

A signal processing circuit (not illustrated) may be provided on a subsequent stage side of the column ADC 12. In Fig. 2, an example in which the column ADC 12 incorporates the function of the signal processing circuit will be described.

The VSL attenuation circuit 18 attenuates a signal at any of a plurality of attenuation rates according to the signal level of the pixel signal transmitted through the vertical signal line VSL, and outputs the attenuated signal. The ramp attenuation circuit 19 attenuates a ramp signal (also referred to as a reference signal) transmitted through a ramp wiring RAMP at an attenuation rate according to the first control signal CS1 and outputs the attenuated signal. The circuit configuration and operation of the VSL attenuation circuit 18 and the ramp attenuation circuit 19 will be described later. In the present specification, "attenuation rate large" refers to a large attenuation amount from a signal before attenuation, and "attenuation rate small" refers to a small attenuation amount from a signal before attenuation.

The comparator & counter 20 includes a comparator and a counter. The comparator compares the pixel signal attenuated by the VSL attenuation circuit 18 with the ramp signal attenuated by the ramp attenuation circuit 19. When the signal level of the pixel signal becomes equal to or higher than the signal level of the ramp signal, the logic of the output signal of the comparator is inverted. The counter performs a counting operation until the logic of the output signal of the comparator is inverted. A digital pixel signal obtained by AD converting the pixel signal is generated on the basis of the count value of the counter.

The logic circuit 14 generates various control signals for controlling the vertical scanning circuit 11, the ramp generation circuit 13, and the column ADC 12. A transmission buffer 16 and a reception buffer 17 are connected to the logic circuit 14. The logic circuit 14 transmits various control signals to the vertical scanning circuit 11, the ramp generation circuit 13, and the column ADC 12 on the basis of a signal input from the outside of the light detection element 1 via the reception buffer 17. Furthermore, the logic circuit 14 performs various types of signal processing on the image data generated by the column ADC 12 and transmits the processed image data to the outside via the transmission buffer 16.

(Configuration of pixel circuit)

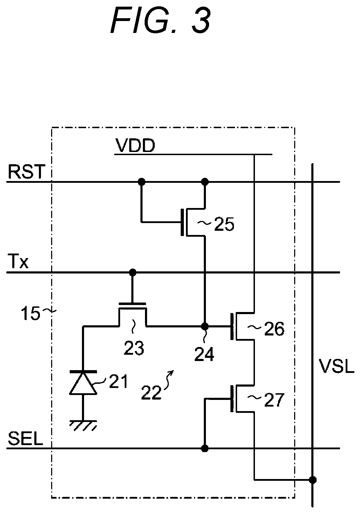

Fig. 3 is a circuit diagram of each pixel 15 in the pixel array section 10. The pixel 15 includes a photoelectric conversion element 21 and a pixel circuit 22. The photoelectric conversion element 21 is a photodiode (PD), for example. In the present specification, the anode of the photoelectric conversion element 21 is set to a reference potential (for example, a ground potential), and the cathode is connected to the pixel circuit 22.

The pixel circuit 22 includes a transfer transistor 23, a floating diffusion (hereinafter, referred to as FD) 24, a reset transistor 25, an amplification transistor 26, and a selection transistor 27. The pixel circuit 22 in Fig. 3 has a 4Tr configuration, and all of the four transistors 23, 25, 26, and 27 are NMOS transistors. Note that the configuration of the pixel circuit 22 is not necessarily limited to Fig. 3, and the number of transistors constituting the pixel circuit 22 is not limited to four.

The drain of the transistor 23 is connected to the FD 24, and the source is connected to the cathode of the photoelectric conversion element 21. The drain of the reset transistor 25 is connected to a power supply voltage VDD node, and the source is connected to the FD 24. The gate of the amplification transistor 26 is connected to the FD 24, the drain is connected to the power supply voltage VDD node, and the source is connected to the drain of the selection transistor 27. The source of the selection transistor 27 is connected to the vertical signal line VSL, and the gate is connected to a row selection line SEL.

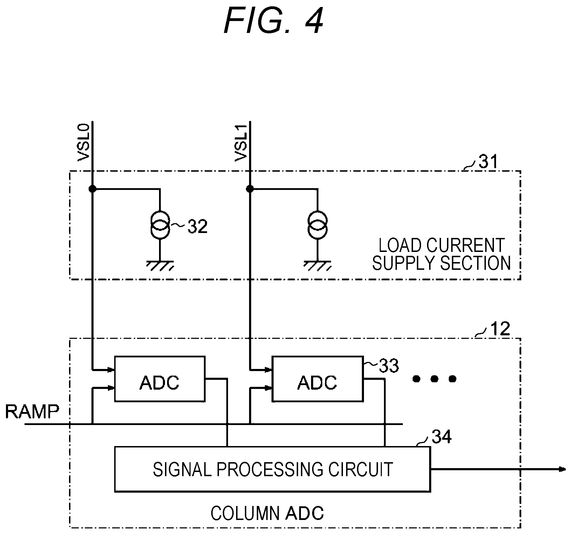

Although not illustrated in Fig. 2, a load current supply section 31 is connected to the plurality of vertical signal lines VSL arranged for each column. Fig. 4 is a block diagram illustrating an example of an internal configuration of the load current supply section 31 and the column ADC 12.

The load current supply section 31 includes a plurality of current sources 32 connected to the plurality of vertical signal lines VSL. Each of the current sources 32 supplies a constant current to the corresponding vertical signal line VSL. The current source 32 includes, for example, a plurality of NMOS transistors.

The column ADC 12 includes a plurality of ADCs 33 and a signal processing circuit 34. Each of the ADCs 33 performs AD conversion on the pixel signal transmitted via the corresponding vertical signal line VSL to generate a digital pixel signal. In this manner, the plurality of ADCs 33 performs AD conversion for each pixel column.

The signal processing circuit 34 performs various types of signal processing on the plurality of digital pixel signals output from the plurality of ADCs 33 to generate image data.

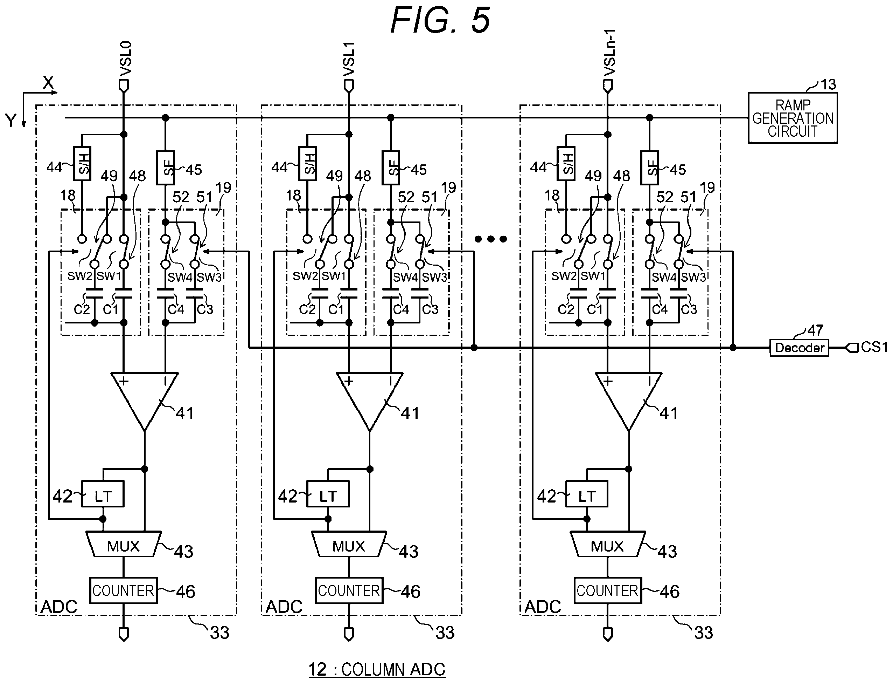

Fig. 5 is a block diagram illustrating an internal configuration of the column ADC 12 according to a first embodiment. As described above, each ADC 33 is connected to the corresponding vertical signal line VSL. A reference signal is supplied from the ramp generation circuit 13 to each ADC 33 via the ramp wiring RAMP.

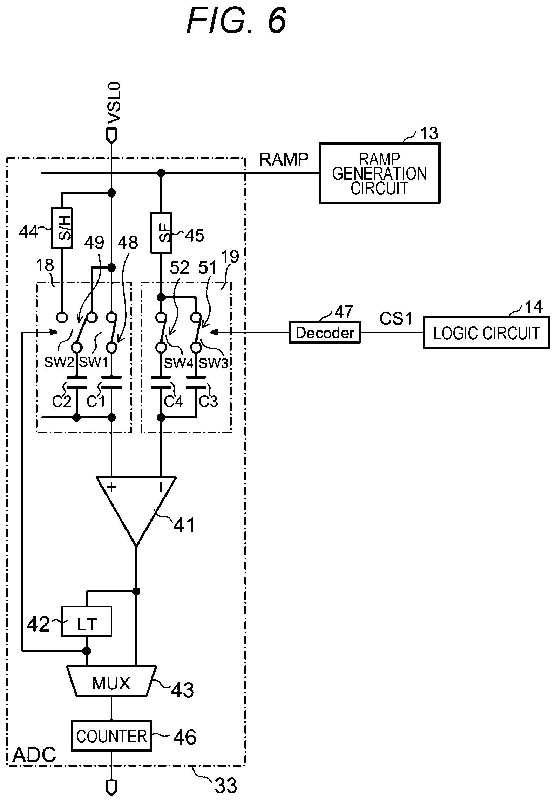

Fig. 6 is a block diagram illustrating a detailed configuration of one ADC 33 in the column ADC 12. Each ADC 33 illustrated in Figs. 5 and 6 includes a comparator 41, a latch circuit (LT) 42, a multiplexer (MUX) 43, a sample and hold circuit (S/H) 44, a VSL attenuation circuit 18, a source follower circuit (SF) 45, a ramp attenuation circuit 19, and a counter 46. The VSL attenuation circuit 18 corresponds to a first attenuation circuit, the ramp attenuation circuit 19 corresponds to a second attenuation circuit, the comparator 41 corresponds to a first comparator, and the counter 46 corresponds to a first counter.

The VSL attenuation circuit 18 attenuates and outputs the pixel signal (D-phase signal) at any of a plurality of (for example, two) attenuation rates according to the signal level. The VSL attenuation circuit 18 attenuates the D-phase signal, and does not assume that the P-phase signal that is a reset level signal is attenuated.

The ramp attenuation circuit 19 attenuates and outputs a ramp signal on the basis of an instruction from the logic circuit 14. The attenuation of the ramp signal refers to loosening the slope of the ramp signal and compressing the time length of the signal change period. The ramp attenuation circuit 19 attenuates and outputs the ramp signal at an attenuation rate corresponding to the control signal before the comparator 41 starts the comparison operation. After the attenuation rate of the ramp attenuation circuit 19 is determined, the VSL attenuation circuit 18 determines the attenuation rate according to the signal level of the pixel signal.

The logic circuit 14 determines the attenuation rate of the ramp signal according to the illuminance of the light incident on the target pixel 15, for example, and notifies the ramp attenuation circuit 19 of the determined attenuation rate. Alternatively, the logic circuit 14 may instruct the ramp attenuation circuit 19 to attenuate the ramp signal on the basis of an external signal.

The logic circuit 14 supplies the first control signal CS1 to the ramp attenuation circuit 19. The ramp attenuation circuit 19 attenuates and outputs the ramp signal at an attenuation rate corresponding to the first control signal CS1.

The first control signal CS1 supplied to the ramp attenuation circuit 19 may be directly supplied from the logic circuit 14, or may be supplied from an attenuation rate setting circuit (Decoder) 47 as illustrated in Fig. 6. The attenuation rate setting circuit 47 is also referred to as a decoder. The attenuation rate setting circuit 47 is required in a case where the first control signal CS1 output from the logic circuit 14 is encoded. In this case, the first control signal CS1 output from the logic circuit 14 is input to the attenuation rate setting circuit 47 to perform decoding processing, and the decoded first control signal CS1 is input to the ramp attenuation circuit 19. The ramp attenuation circuit 19 attenuates the ramp signal at an attenuation rate corresponding to the first control signal CS1 decoded by the attenuation rate setting circuit 47. For example, in a case where the first control signal CS1 output from the logic circuit 14 includes information on the attenuation rates of the ramp attenuation circuits 19 in all the ADCs 33, the attenuation rate setting circuit 47 for each ADC 33 is only required to extract its own attenuation rate information. Therefore, the logic circuit 14 can set an individual attenuation rate to each ramp attenuation circuit 19 in each ADC 33.

The comparator 41 compares the output signal of the VSL attenuation circuit 18 with the output signal of the ramp attenuation circuit 19. More specifically, the comparator 41 performs a first determination process of comparing the reset level signal (P-phase signal) with the ramp signal, a second determination process of determining whether or not the illuminance of the light incident on the pixel 15 is higher than a predetermined reference illuminance, and a third determination process of comparing the photoelectrically converted pixel signal (D-phase signal) with the ramp signal. The second determination process is performed between the first determination process and the third determination process. The second determination process is performed on the basis of a result of comparison between the pixel signal on the vertical signal line VSL and the ramp signal set to a predetermined signal level by the comparator 41.

When the signal level of the output signal of the VSL attenuation circuit 18 becomes higher than or equal to the signal level of the output signal of the ramp attenuation circuit 19, the logic of the output signal of the comparator 41 changes. The latch circuit 42 holds the output signal of the comparator 41 at a predetermined timing. Specifically, the latch circuit 42 holds a result of determination by the comparator 41 as to whether or not the illuminance of the light incident on the pixel 15 exceeds a predetermined reference illuminance. The multiplexer 43 selects and outputs either the signal held in the latch circuit 42 or the output signal of the comparator 41.

The counter 46 continuously performs the counting operation during a period until the logic of the signal selected by the multiplexer 43 changes.

The sample and hold circuit 44 samples and holds a reset level signal (P-phase signal) transmitted through the vertical signal line VSL. The sample and hold circuit 44 has a function of reducing kTC noise.

The source follower circuit 45 rapidly changes the potential of the input node of the ramp attenuation circuit 19 according to a change in the signal level of the ramp signal transmitted through the ramp wiring RAMP.

In a case where it is determined that the illuminance of the light incident on the pixel 15 exceeds the predetermined reference illuminance in the second determination process at the time of performing the third determination process described above, the VSL attenuation circuit 18 attenuates and outputs the pixel signal (D-phase signal). In this specification, processing performed by the VSL attenuation circuit 18 may be referred to as adaptive attenuation.

The VSL attenuation circuit 18 includes a first series circuit 48 and a second series circuit 49 connected in parallel between the vertical signal line VSL and the non-inverting input terminal of the comparator 41. The first series circuit 48 includes a first switch SW1 and a first capacitor C1 connected in series between the vertical signal line VSL and the non-inverting input terminal of the comparator 41. The second series circuit 49 includes a second switch SW2 and a second capacitor C2 connected in series between the vertical signal line VSL and the non-inverting input terminal of the comparator 41.

The first switch SW1 switches whether or not one end of the first capacitor C1 is connected to the vertical signal line VSL. The second switch SW2 selects either the vertical signal line VSL or the output node of the sample and hold circuit 44, and is connected to one end of the second capacitor C2. The first switch SW1 and the second switch SW2 are switch-controlled by a hold signal from the latch circuit 42. The latch circuit 42 holds a state in which the output logic of the comparator 41 has changed when the signal level of the pixel signal is larger than a predetermined threshold.

In a case where the signal level of the pixel signal is less than or equal to the predetermined threshold, the vertical signal line VSL and one end of the first capacitor C1 are connected via the first switch SW1, and the vertical signal line VSL and one end of the second capacitor C2 are connected via the second switch SW2. Therefore, the first capacitor C1 and the second capacitor C2 are connected in parallel between the vertical signal line VSL and the non-inverting input terminal of the comparator 41. In this case, the VSL attenuation circuit 18 outputs the pixel signal on the vertical signal line VSL without attenuating the pixel signal. Therefore, the pixel signal is input to the non-inverting input terminal of the comparator 41 without being attenuated.

On the other hand, in a case where the signal level of the pixel signal is larger than the predetermined threshold, the vertical signal line VSL and one end of the first capacitor C1 are connected via the first switch SW1. Furthermore, the output node of the sample and hold circuit 44 is connected to the second capacitor C2 via the second switch SW2. A reset level signal is held in the sample and hold circuit 44. Therefore, the first capacitor C1 and the second capacitor C2 are connected in series between the vertical signal line VSL and the output node of the sample and hold circuit 44.

Here, when the capacitance value of the first capacitor C1 is C1, the capacitance value of the second capacitor C2 is C2, the voltage between both electrodes of the first capacitor C1 is V1, and the voltage between both electrodes of the second capacitor C2 is V2, the following Formula (1) is established.

$$C1 \times V1 = C2 \times V2...(1)$$

Since the voltage V1 at the pixel signal level is applied to the first capacitor C1 and the voltage V2 at the reset level is applied to the second capacitor C2, the voltage Vsig expressed by the following Formula (2) is applied to both ends of the combined capacitance of the first capacitor C1 and the second capacitor C2.

$$Vsig = V1 + V2...(2)$$

When Formula (2) is substituted into Formula (1) and transformed, the following Formula (3) is obtained.

$$V1 = (C2 \times Vsig)/(C1 + C2) \quad \dots(3)$$

The voltage V1 is a voltage level of the output signal of the VSL attenuation circuit 18. As can be seen from Formula (3), a signal obtained by attenuating the pixel signal by the capacitance ratio between the first capacitor C1 and the second capacitor C2 is output from the VSL attenuation circuit 18.

As described above, the comparator 41 in the ADC 33 in Figs. 5 and 6 includes the second determination process of comparing the pixel signal with the predetermined threshold between the first determination process of comparing the reset level signal with the ramp signal and the third determination process of comparing the pixel signal with the ramp signal. In the second determination process, it is determined whether or not the illuminance of the light incident on the pixel 15 is higher than the reference illuminance. When it is determined that the pixel signal is larger than the predetermined threshold, that is, the illuminance of the incident light is higher than the reference illuminance, the VSL attenuation circuit 18 switches the first switch SW1 and the second switch SW2 to attenuate and output the pixel signal. Therefore, the comparator 41 compares the attenuated pixel signal with the ramp signal in the third determination process.

The ramp attenuation circuit 19 includes a third series circuit 51 and a fourth series circuit 52 connected in parallel between the output node of the source follower circuit 45 and the inverting input terminal of the comparator 41. The third series circuit 51 includes a third switch SW3 and a third capacitor C3 connected in series between the output node of the source follower circuit 45 and the inverting input terminal of the comparator 41. The fourth series circuit 52 includes a fourth switch SW4 and a fourth capacitor C4 connected in series between the output node of the source follower circuit 45 and the inverting input terminal of the comparator 41.

The third switch SW3 and the fourth switch SW4 are switch-controlled on the basis of the first control signal CS1 output from the logic circuit 14 and decoded by the attenuation rate setting circuit 47. The attenuation rate of the ramp signal is controlled by performing switching control of the third switch SW3 and the fourth switch SW4.

As described above, the ramp attenuation circuit 19 performs switching control of the third switch SW3 and the fourth switch SW4 on the basis of the first control signal CS1 such that the reference signal is attenuated at an attenuation rate according to the capacitance ratio of the third capacitor C3 and the fourth capacitor C4.

The logic circuit 14 outputs the first control signal CS1 on the basis of the illuminance of the light incident on the pixel 15, for example.

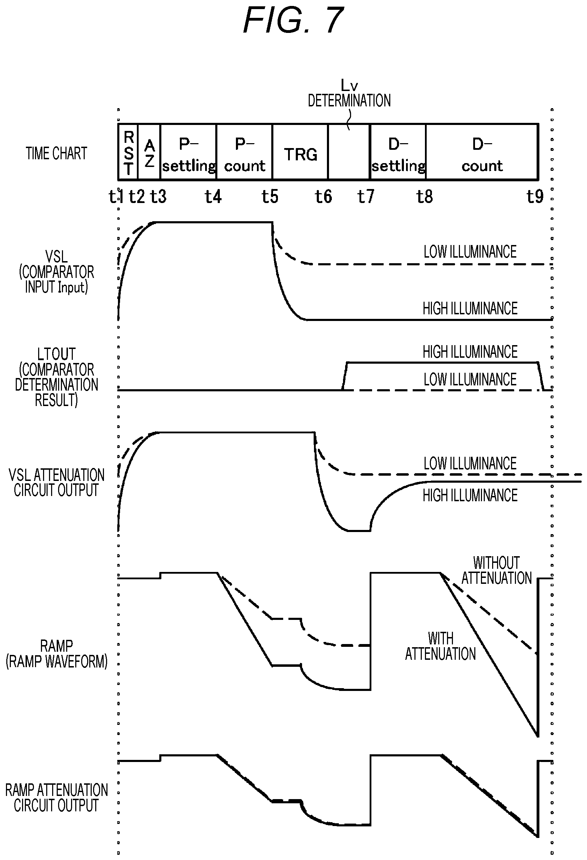

Fig. 7 is a diagram of signal waveforms inside the ADC 33. Fig. 7 illustrates waveforms of the pixel signal on the vertical signal line VSL, the output signal LTOUT of the latch circuit 42, the output signal of the VSL attenuation circuit 18 input to the non-inverting input terminal of the comparator 41, the ramp signal on the ramp wiring RAMP, and the output signal of the ramp attenuation circuit 19 input to the inverting input terminal of the comparator 41. In Fig. 7, a signal waveform of each signal in a case where high illuminance light is incident on the pixel 15 is indicated by a solid line, and a signal waveform of each signal in a case where low illuminance light is incident is indicated by a broken line. The voltage level of the pixel signal on the vertical signal line VSL is lower in a case where high illuminance light is incident on the pixel 15 than in a case where low illuminance light is incident.

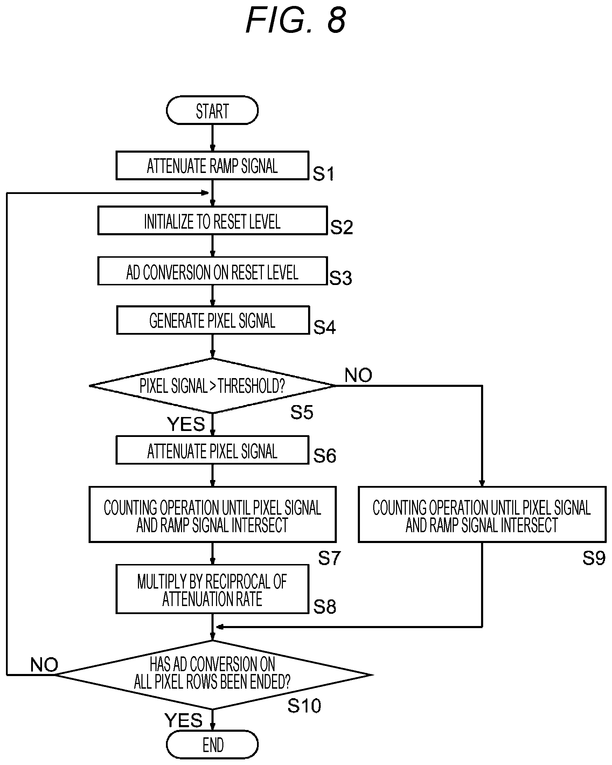

Fig. 8 is a flowchart illustrating a processing operation of the light detection element 1 according to the first embodiment. The flowchart of Fig. 8 is started when an imaging start instruction signal is supplied from the imaging control section 5 of Fig. 1 to the light detection element 1. Before starting imaging for each pixel row, the ramp attenuation circuit 19 attenuates the ramp signal at an attenuation rate corresponding to the control signal (step S1). Next, the light detection element 1 performs imaging for each pixel row from the first pixel row. Each pixel 15 of the pixel row executes the processing of the flowchart of Fig. 8 in parallel.

First, the reset transistor 25 in each pixel 15 of the target pixel row is turned on. Therefore, the potential of the FD 24 is initialized to the reset level (step S2, time t1 to t2). When the selection transistor 27 of each pixel 15 is turned on, a reset level signal is transmitted via the vertical signal line VSL.

The first to fourth capacitors C1 to C4 in each ADC 33 are initialized by an AZ signal (times t2 to t3). The sample and hold circuit 44 in each ADC 33 samples the reset level signal (time t3 to t4), and holds the reset level signal after the signal level is stabilized (time t4 to t5). Furthermore, each ADC 33 performs AD conversion on a signal of a reset level on the corresponding vertical signal line VSL (step S3).

Thereafter, each pixel 15 turns on the transfer transistor 23 to transfer the charge accumulated in the photoelectric conversion element 21 to the FD 24 (times t5 to t6), and generates a pixel signal (step S4).

The comparator 41 in each ADC 33 compares the pixel signal on the corresponding vertical signal line VSL with the ramp signal. Specifically, it is determined whether or not the signal level of the pixel signal is larger than a predetermined threshold (step S5, time t6 to t7). The logic of the output signal of the comparator 41 changes depending on whether the signal level of the pixel signal is larger than a threshold. The latch circuit 42 on the subsequent stage side of the comparator 41 holds the output signal of the comparator 41 at a predetermined timing. When it is determined that the signal level of the pixel signal is higher than the threshold, the first switch SW1 and the second switch SW2 in the VSL attenuation circuit 18 are switch-controlled by the hold signal held in the latch circuit 42, and the VSL attenuation circuit 18 attenuates the signal level of the pixel signal and outputs the attenuated level (step S6).

The ramp generation circuit 13 can change the slope of the ramp signal depending on the illuminance. As illustrated in Fig. 7, the slope of the ramp signal is made larger at high illuminance than at low illuminance. The ramp attenuation circuit 19 attenuates and compresses the ramp signal on the basis of the first control signal CS1 from the logic circuit 14. Therefore, as illustrated in the signal waveform of the ramp signal of Fig. 7, the slope of the ramp signal becomes gentle. In the example of Fig. 7, as a result of attenuating the ramp signal by the ramp attenuation circuit 19, the ramp generation circuit 13 has the same waveform as the ramp signal (broken line) before changing the slope of the amplifier signal, but this is merely an example. Furthermore, in a period (t6 to t7) for determining the illuminance of the pixel signal, the signal level of the ramp signal is set to a threshold level for determining the illuminance of the pixel signal.

Thereafter, after the signal level of the pixel signal is stabilized (times t7 to t8), the comparator 41 compares the pixel signal with the ramp signal (times t8 to t9). When the pixel signal becomes higher than the ramp signal, the logic of the output signal of the comparator 41 changes, and the counter 46 stops the counting operation (step S7). Thereafter, the signal processing circuit 34 in the column ADC 12 multiplies the count value by the value of the reciprocal of the attenuation rate of the VSL attenuation circuit 18 to generate a digital pixel signal (step S8).

On the other hand, when it is determined in step S4 that the signal level of the pixel signal is equal to or less than the predetermined threshold value, the VSL attenuation circuit 18 outputs the pixel signal without attenuating the pixel signal. The comparator 41 compares the pixel signal with the ramp signal, and changes the logic of the output signal when the pixel signal becomes higher than the ramp signal, and the counter 46 stops the operation of cown (step S9). The count value of the counter 46 is a digital pixel signal.

When the processing of step S8 or S9 ends, it is determined whether or not the AD conversion processing has been performed on all the pixel rows of the pixel array section 10 (step S10). If there is still a pixel row on which the AD conversion processing has not been performed, the processing in and after step S1 is repeated for each pixel row. When the AD conversion processing for all the pixel rows ends, the processing of Fig. 8 ends.

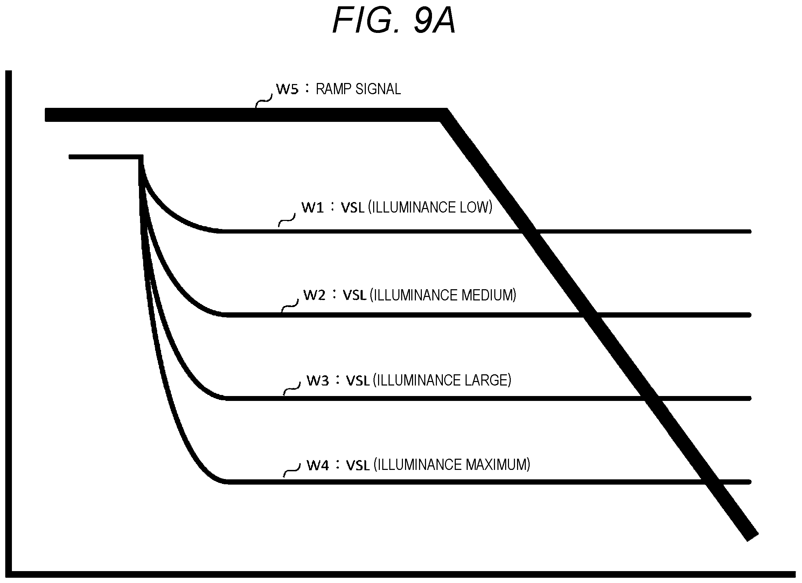

Fig. 9A is a signal waveform diagram of a pixel signal on the vertical signal line VSL. Fig. 9A illustrates four signal waveforms w1 to w4 and a ramp signal waveform w5 in a case where the illuminance of light incident on the pixel 15 is low, medium, large, and maximum. As illustrated in Fig. 9A, the signal level of the pixel signal changes according to the illuminance of the light incident on the pixel 15, and the higher the illuminance, the lower the signal level of the pixel signal. For this reason, in a case where the slope of the ramp signal is constant, the time during which the pixel signal and the ramp signal cross each other is delayed as the illuminance is higher, and more time is required for the AD conversion processing.

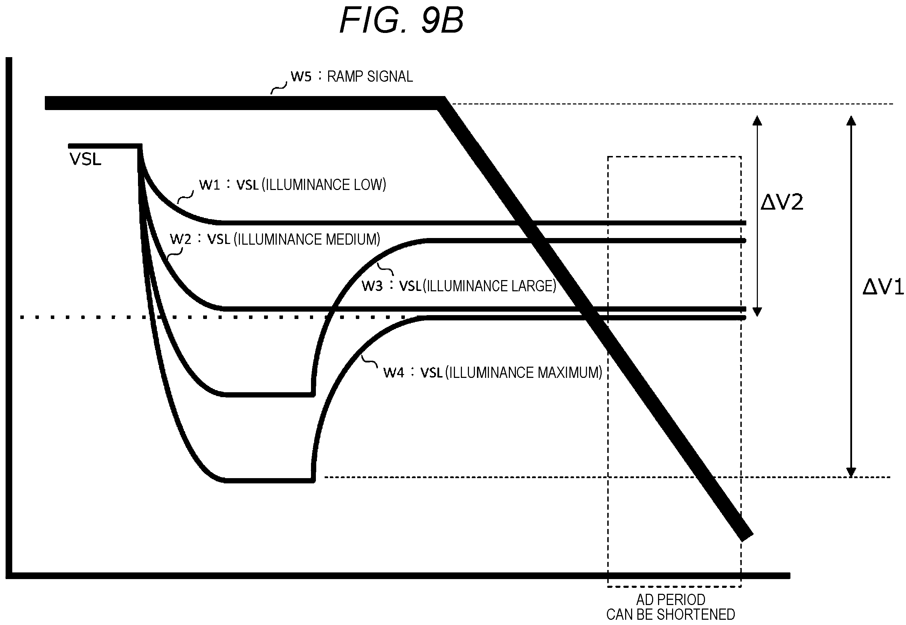

Fig. 9B is a signal waveform diagram of the pixel signal attenuated by the VSL attenuation circuit 18. In the example of Fig. 9B, the VSL attenuation circuit 18 does not attenuate the pixel signal when the illuminance is low or medium, and attenuates the pixel signal when the illuminance is large or maximum. Therefore, the time at which the pixel signal and the ramp signal intersect when the illuminance is high or maximum can be made earlier than in Fig. 9A, and the speed of the AD conversion processing can be increased. In Fig. 9B, the potential difference between the pixel signal and the ramp signal when the illuminance is maximum is $\Delta V1$ in a case where the pixel signal is not attenuated by the VSL attenuation circuit 18. However, by attenuating the pixel signal by the VSL attenuation circuit 18, the above-described potential difference can be reduced to $\Delta V2$, and the time at which the pixel signal intersects the ramp signal can be significantly advanced.

The present embodiment is characterized by attenuating not only a pixel signal but also a ramp signal. The slope of the ramp signal is controlled by the ramp generation circuit 13. On the basis of the instruction from the logic circuit 14, the ramp generation circuit 13 makes the slope of the ramp signal steeper in the case of high illuminance (low analog gain) than in the case of low illuminance.

Moreover, the ramp attenuation circuit 19 according to the present embodiment attenuates the ramp signal on the basis of the first control signal CS1 from the logic circuit 14.

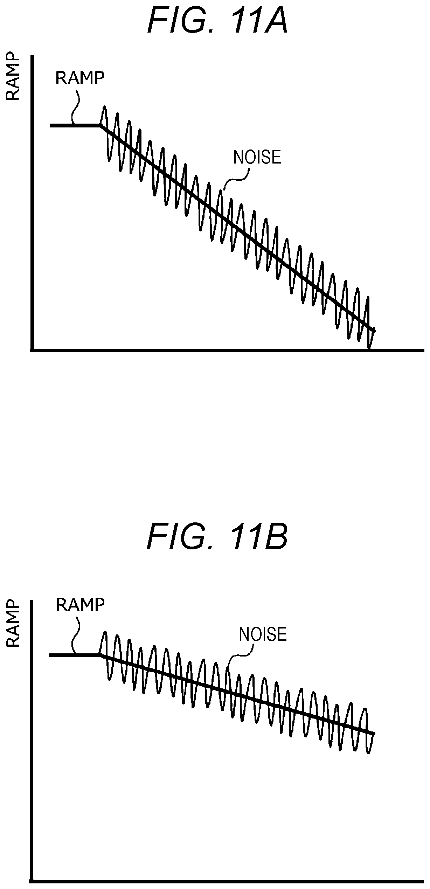

Since the ramp signal generated by the ramp generation circuit 13 is supplied to all the ADCs 33 via the common ramp wiring RAMP, noise is superimposed on the ramp signal. Fig. 11A is a diagram schematically illustrating a state in which noise is superimposed on a ramp signal generated by the ramp generation circuit 13 and transmitted through the ramp wiring RAMP. Fig. 11B is a diagram illustrating an example in which the signal waveform of the ramp signal is changed in the ramp generation circuit 13. As can be seen from Figs. 11A and 11B, even if the signal waveform of the ramp signal is controlled by the ramp generation circuit 13, noise superimposed on the ramp signal cannot be reduced.

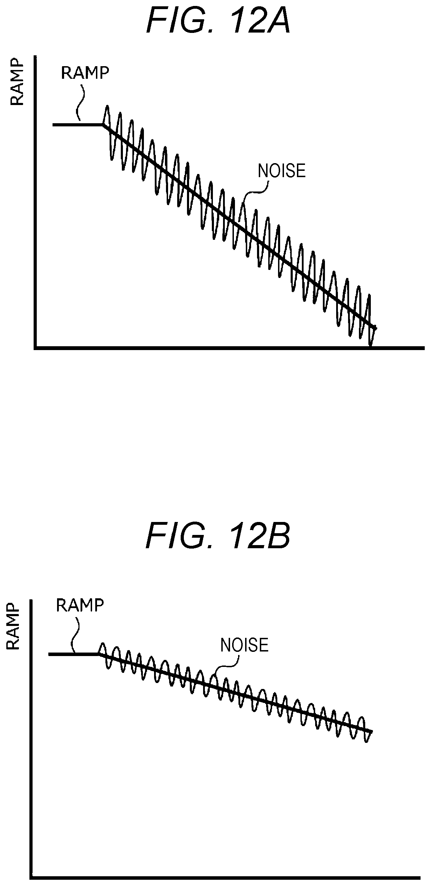

Fig. 12A is a signal waveform diagram of the ramp signal supplied from the ramp generation circuit 13 to the ramp wiring RAMP similarly to Fig. 11A. Fig. 12B is a signal waveform diagram of a ramp signal obtaining by attenuating the ramp signal of Fig. 12A with the ramp attenuation circuit 19.

As can be seen by comparing Fig. 11B with Fig. 12B, by attenuating the ramp signal by the ramp attenuation circuit 19, noise superimposed on the ramp signal can also be attenuated, and the S/N ratio can be improved.

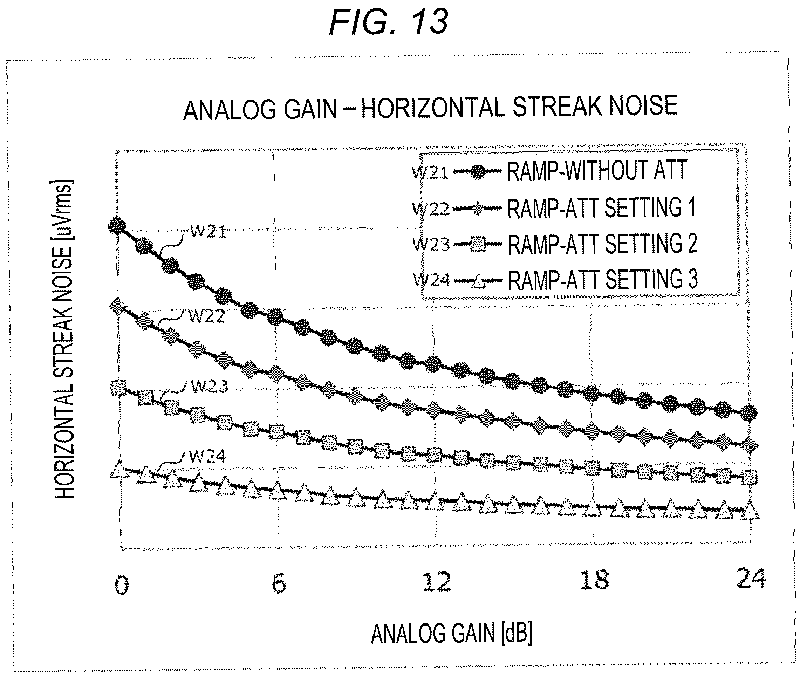

Fig. 13 is a diagram illustrating horizontal streak noise appearing in a captured image. In Fig. 13, the horizontal axis represents the analog gain [dB], and the vertical axis represents the magnitude of the horizontal streak noise [uVrms]. Fig. 13 illustrates a waveform w21 in a case where the ramp signal is not attenuated by the ramp attenuation circuit 19, a waveform w22 in a case where the ramp signal is attenuated at the first attenuation rate, a waveform w23 in a case where the ramp signal is attenuated at the second attenuation rate, and a waveform w24 in a case where the ramp signal is attenuated at the third attenuation rate. An example in which the second attenuation rate is larger than the first attenuation rate and the third attenuation rate is larger than the second attenuation rate is shown. As can be seen from the signal waveforms w21 to w4 of Fig. 13, the larger the attenuation rate of the ramp signal in the ramp attenuation circuit 19, the more difficult the horizontal streak noise is to be visually recognized, and the image quality of the captured image can be improved.

As described above, in the first embodiment, by attenuating the ramp signal by the ramp attenuation circuit 19, the noise superimposed on the ramp signal can also be attenuated, and the horizontal streak noise can be reduced. Furthermore, in a case where the illuminance of the light incident on the pixel 15 is high, the attenuation rate of the pixel signal is controlled by the VSL attenuation circuit 18 according to the illuminance, so that the time during which the pixel signal and the ramp signal intersect can be shortened, and the AD conversion speed can be increased.

<Second embodiment>

A light detection element 1 according to a second embodiment has a block configuration similar to that in Fig. 2. Furthermore, the imaging device 2 including the light detection element 1 according to the second embodiment has a block configuration similar to that of Fig. 1. Hereinafter, differences from the light detection element 1 according to the first embodiment will be mainly described.

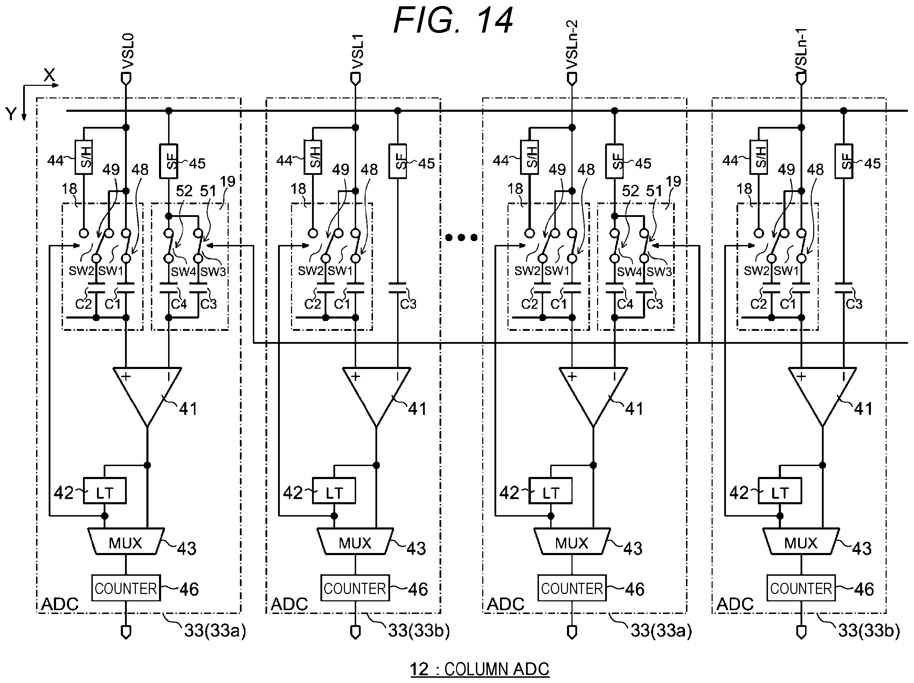

Fig. 14 is a block diagram illustrating a schematic configuration of a column ADC 12 included in a light detection element 1 according to the second embodiment. The column ADC 12 of Fig. 14 includes a plurality of ADCs 33 (Hereinafter, referred to as a first ADC 33a.) having a block configuration similar to that of Fig. 5 and a plurality of ADCs 33 (Hereinafter, referred to as a second ADC 33b.) not including the ramp attenuation circuit 19. The plurality of second ADCs 33b arranged in the first direction X is arranged between the plurality of first ADCs 33a also arranged in the first direction X. A VSL attenuation circuit 18 in the first ADC 33a of Fig. 14 corresponds to a first attenuation circuit, a ramp attenuation circuit 19 corresponds to a second attenuation circuit, a comparator 41 corresponds to a first comparator, and a counter 46 corresponds to a first counter. A VSL attenuation circuit 18 in the second ADC 33b in Fig. 14 corresponds to a third attenuation circuit, a comparator 41 corresponds to a second comparator, and the counter 46 corresponds to a second counter.

Fig. 14 illustrates an example in which the first ADCs 33a and the second ADCs 33b are alternately arranged, but this is an example, and various arrangement forms can be taken. For example, an arrangement mode in which two or more first ADCs 33a are arranged adjacent to each other in the first direction X, and one or more second ADCs 33b are arranged next to them may be adopted. Furthermore, the numbers of the first ADCs 33a and the second ADCs 33b are not necessarily the same.

Depending on whether or not to attenuate the ramp signal, there is a possibility that the timing at which the pixel signal and the ramp signal intersect with each other is shifted. Therefore, in a signal processing circuit 34 on a subsequent stage side of the comparator 41, it is necessary to adjust a coefficient to be multiplied by the count value output from the counter 46 depending on whether or not the ramp signal is attenuated.

In the column ADC 12 of Fig. 14, since it is not necessary to provide the ramp attenuation circuit 19 inside all the ADCs 33, the circuit area can be reduced as compared with the column ADC 12 according to the first embodiment. In some of the ADCs 33, the ramp signal is attenuated, so that the horizontal streak noise can be reduced.

<Third embodiment>

A light detection element 1 according to a third embodiment has a block configuration similar to that in Fig. 2. Furthermore, an imaging device 2 including the light detection element 1 according to the third embodiment has a block configuration similar to that of Fig. 1. Hereinafter, differences from the light detection element 1 according to the first embodiment will be mainly described.

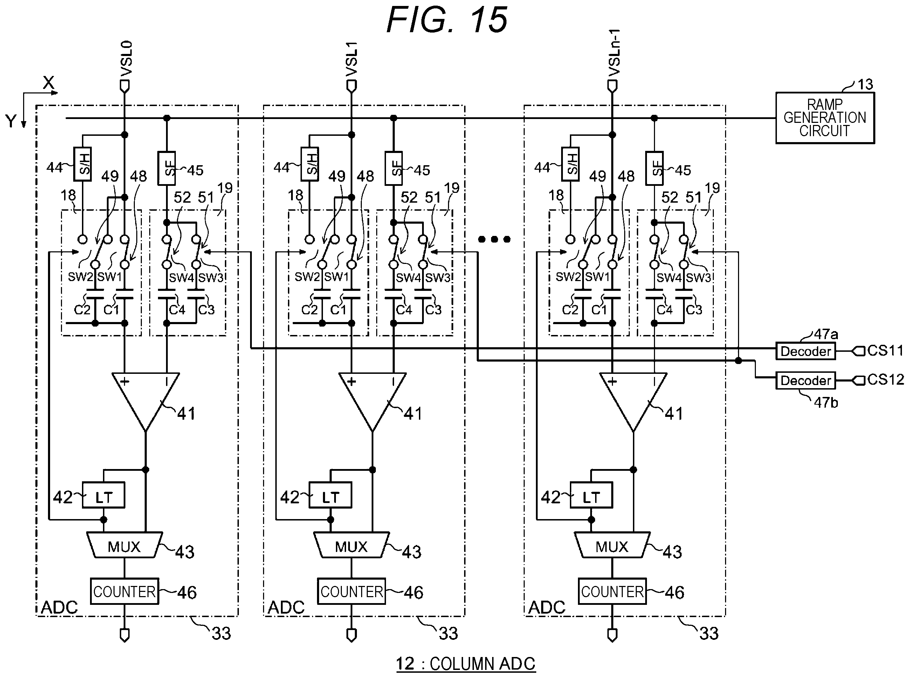

Fig. 15 is a block diagram illustrating a schematic configuration of a column ADC 12 included in the light detection element 1 according to the third embodiment. The column ADC 12 in Fig. 15 is characterized in that the attenuation rate of the ramp signal can be varied for each of ADCs 33.

Two types of first control signals CS1 are supplied from a logic circuit 14 to the column ADC 12. One first control signal CS11 is decoded by an attenuation rate setting circuit 47a, and the other first control signal CS12 is decoded by an attenuation rate setting circuit 47b.

Among the plurality of ADCs 33 arranged in the first direction X, the ramp attenuation circuit 19 of the odd-numbered ADC 33 determines the attenuation rate of the ramp signal on the basis of the first control signal CS11 decoded by the attenuation rate setting circuit 47a. The ramp attenuation circuit 19 of the even-numbered ADC 33 determines the attenuation rate of the ramp signal on the basis of the first control signal CS12 decoded by the attenuation rate setting circuit 47b. Therefore, the attenuation rate of the ramp signal can be made different between the odd-numbered ADC 33 and the even-numbered ADC 33 in the column ADC 12. For example, the VSL attenuation circuit 18 in the odd-numbered ADC 33 in Fig. 15 corresponds to a first attenuation circuit, the ramp attenuation circuit 19 in the odd-numbered ADC 33 corresponds to a second attenuation circuit, the VSL attenuation circuit 18 in the even-numbered ADC 33 corresponds to a third attenuation circuit, and the ramp attenuation circuit 19 in the even-numbered ADC 33 corresponds to a fourth attenuation circuit.

Note that the column ADC 12 according to the third embodiment can take various modifications. For example, the locations and number of the ADCs 33 that determine the attenuation rate of the ramp signal on the basis of the first control signal CS11 (or the first control signal CS12) decoded by the attenuation rate setting circuits 47a and 47b are arbitrary.

Furthermore, the logic circuit 14 may supply three or more types of the first control signals CS1 to the column ADC 12. Therefore, each ADC 33 can attenuate the ramp signal at three or more types of attenuation rates. For example, the attenuation rate may be individually adjusted for each ADC 33.

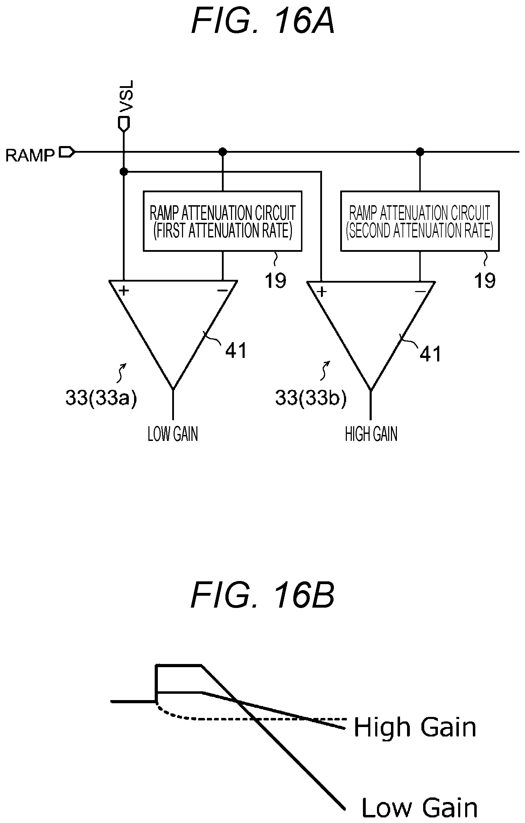

Moreover, a configuration in which the plurality of ADCs 33 is connected to one vertical signal line VSL can also be adopted. Figs. 16A and 16B are block diagrams illustrating a schematic configuration of a column ADC 12 according to a first modification of the third embodiment.

Fig. 16A is a block diagram in a case where two ADCs 33 (Hereinafter, referred to as a first ADC 33a and a second ADC 33b.) are connected to one vertical signal line VSL, and Fig. 16B is a signal waveform diagram of a ramp signal and a pixel signal input to the comparator 41 in the ADC 33 of Fig. 16A. Fig. 16A illustrates a simplified block configuration of the first ADC 33a and the second ADC 33b. The first ADC 33a and the second ADC 33b in Fig. 16A differ from each other in resolution for AD conversion. The first ADC 33a has low resolution (low analog gain), whereas the second ADC 33b has high resolution (high analog gain).

The first ADC 33a and the second ADC 33b are connected to the same vertical signal line VSL. The ramp attenuation circuit 19 of the first ADC 33a is set to the first attenuation rate and generates a ramp signal having a steep slope as illustrated in Fig. 16B. The ramp attenuation circuit 19 of the second ADC 33b is set to the second attenuation rate, and generates a ramp signal having a gentler slope than the ramp attenuation circuit 19 of the first ADC 33a as illustrated in Fig. 16B.

Since the resolution of the AD conversion can be improved when the slope of the ramp signal is gentle, the second ADC 33b can have higher resolution of the AD conversion than the first ADC 33a.

As described above, the column ADC 12 according to the third embodiment can perform a plurality of AD conversions having different resolutions (analog gains) for each vertical signal line VSL. The column ADC 12 in Fig. 16A has two types of ADCs 33 (the first ADC 33a and the second ADC 33b) having different resolutions (analog gains), but three or more types of ADCs 33 having different resolutions (analog gains) may be provided in the column ADC 12. In this case, the number of attenuation rate setting circuits 47 according to the number of ADCs 33 having different resolutions may be provided.

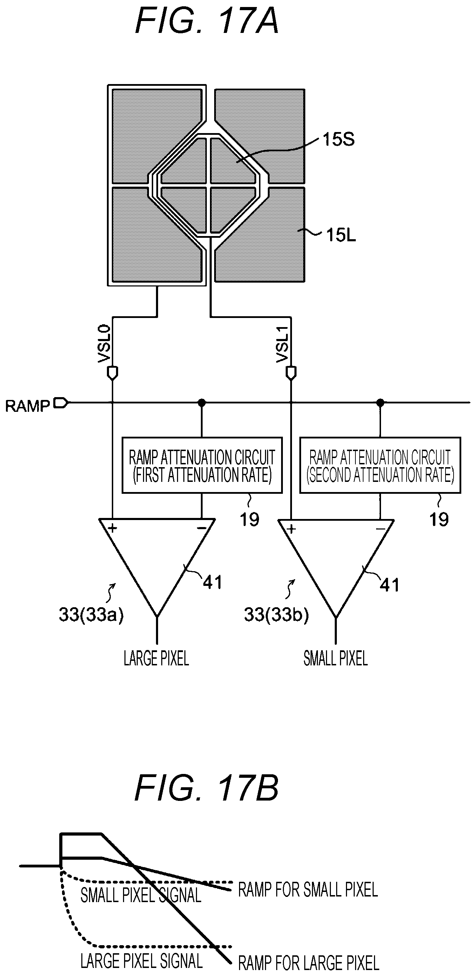

Figs. 17A and 17B are block diagrams illustrating a schematic configuration of a column ADC 12 according to a second modification of the third embodiment. Fig. 17A is a block diagram of two ADCs 33 (Hereinafter, the first ADC 33a and the second ADC 33b may be referred to.) that perform AD conversion on pixel signals from two types of pixels 15 having different pixel sizes, and Fig. 17B is a signal waveform diagram of a ramp signal and a pixel signal input to the comparator 41 in the ADC 33 of Fig. 17A.

Fig. 17A illustrates a configuration in which four large pixels 15L are arranged around four small pixels 15S. The four small pixels 15S may share one vertical signal line VSL and one ADC 33, or may be separately provided with the vertical signal line VSL and the ADC 33. Similarly, the four large pixels 15L may share one vertical signal line VSL and one ADC 33, or may be separately provided with the vertical signal line VSL and the ADC 33.

The signal level of the pixel signal of the large pixel 15L changes more greatly than that of the pixel signal of the small pixel 15S. Therefore, the attenuation rate (first attenuation rate) of the ramp attenuation circuit 19 in the ADC 33a for the large pixel 15L is set to be smaller than the attenuation rate (second attenuation rate) of the ramp attenuation circuit 19 in the ADC 33b for the small pixel 15S as illustrated in Fig. 17B.

As described above, the column ADC 12 illustrated in Figs. 17A and 17B can adjust the attenuation rate of the ramp attenuation circuit 19 in each of the ADCs 33a and 33b in accordance with the pixel size in a case where a plurality of types of pixels 15 having different pixel sizes is mixed.

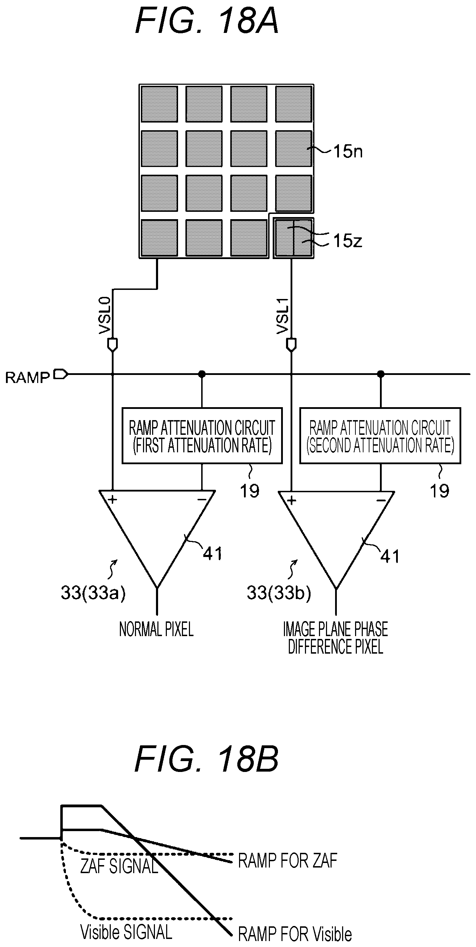

Figs. 18A and 18B are block diagrams illustrating a schematic configuration of a column ADC 12 according to a third modification of the third embodiment. The third modification is a case where the normal pixel 15n and the image plane phase difference pixel 15z are mixed in the pixel array section 10.

Fig. 18A illustrates the ADC 33a for the normal pixel 15n and the ADC 33b for the image plane phase difference pixel 15z. In general, the number of the normal pixels 15n is larger than the number of the image plane phase difference pixels 15z, but the ratio of the number of the normal pixels 15n and the number of the image plane phase difference pixels 15z is arbitrary. The image plane phase difference pixel 15z divides the normal pixel 15n into two, and detects a phase difference between pixel signals in each divided pixel 15. Therefore, the signal level of the pixel signal (ZAF signal) of the image plane phase difference pixel 15z is smaller than the signal level of the pixel signal (Visible signal) of the normal pixel 15n. Therefore, as illustrated in Fig. 18B, the attenuation rate (first attenuation rate) of the ramp attenuation circuit 19 in the ADC 33 for the normal pixel 15n is desirably smaller than the attenuation rate (second attenuation rate) of the ramp attenuation circuit 19 in the ADC 33 for the image plane phase difference pixel 15z.

As described above, in the column ADC 12 illustrated in Figs. 18A and 18B, in a case where the normal pixel 15n and the image plane phase difference pixel 15z are mixed, the ADC 33 for the normal pixel 15n and the ADC 33 for the image plane phase difference pixel 15z can have different attenuation rates of the ramp attenuation circuit 19.

<Fourth embodiment>

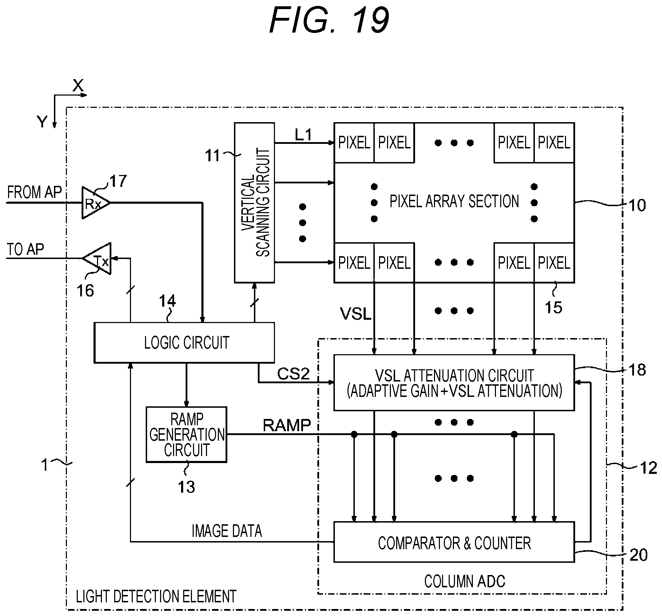

Fig. 19 is a block diagram illustrating a schematic configuration of a light detection element 1 according to a fourth embodiment. An imaging device 2 including the light detection element 1 according to the fourth embodiment has a block configuration similar to that in Fig. 1. Hereinafter, differences from the light detection element 1 according to the first embodiment will be mainly described.

The light detection element 1 according to the fourth embodiment includes a column ADC 12 having a configuration different from that of the light detection elements 1 according to the first to third embodiments. Specifically, as illustrated in Fig. 19, the ramp attenuation circuit 19 does not exist inside the column ADC 12. That is, the column ADC 12 in Fig. 19 includes a VSL attenuation circuit 18 and a comparator & counter 20, but does not include the ramp attenuation circuit 19. The light detection element 1 according to the fourth embodiment has a block configuration similar to that in Fig. 2 except for the column ADC 12.

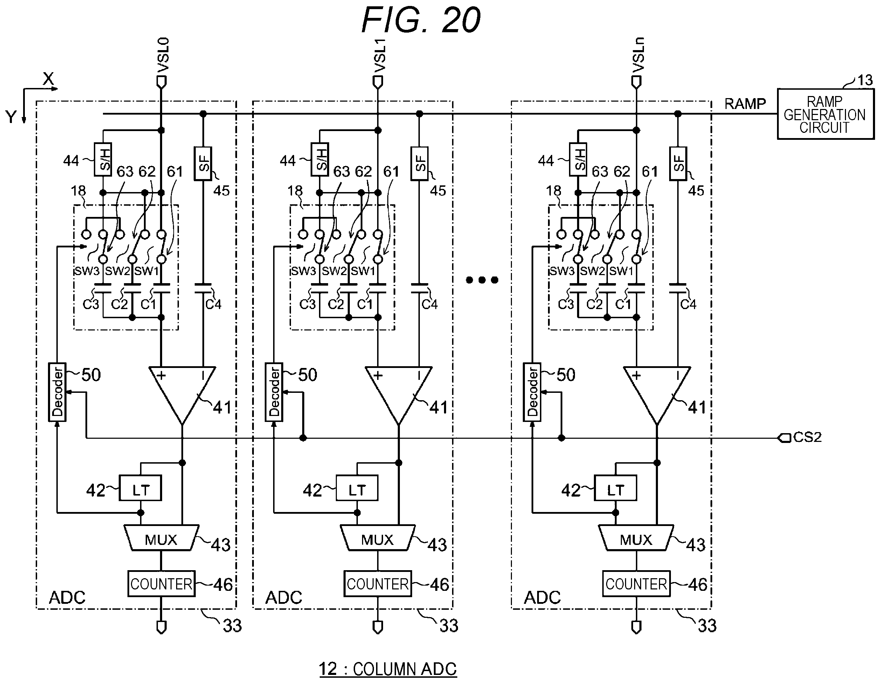

Fig. 20 is a block diagram illustrating an internal configuration of a column ADC 12 according to the fourth embodiment. Each ADC 33 in the column ADC 12 includes a comparator 41, a latch circuit 42, a multiplexer 43, a sample and hold circuit 44, the VSL attenuation circuit 18, and a source follower circuit 45.

The VSL attenuation circuit 18 attenuates the pixel signal at any of attenuation rates of 3 or more according to the signal level and outputs the attenuated pixel signal. More specifically, in a case where the signal level of the pixel signal exceeds a predetermined threshold, the VSL attenuation circuit 18 attenuates the pixel signal at any of two or more attenuation rates according to the signal level of the pixel signal on the basis of the second control signal CS2 and outputs the attenuated pixel signal, and in a case where the signal level of the pixel signal is less than or equal to the predetermined threshold, the VSL attenuation circuit 18 attenuates the pixel signal at any of two or more attenuation rates according to the signal level of the pixel signal on the basis of the second control signal CS2 and outputs the attenuated pixel signal.

The VSL attenuation circuit 18 includes a first series circuit 61, a second series circuit 62, and a third series circuit 63 connected in parallel between the vertical signal line VSL and the non-inverting input terminal of the comparator 41. The first series circuit 61 includes a first switch SW1 and a first capacitor C1 connected in series between the vertical signal line VSL and the non-inverting input terminal of the comparator 41. The second series circuit 62 includes a second switch SW2 and a second capacitor C2 connected in series between the vertical signal line VSL and the non-inverting input terminal of the comparator 41. The third series circuit 63 includes a third switch SW3 and a third capacitor C3 connected in series between the vertical signal line VSL and the non-inverting input terminal of the comparator 41.

The first switch SW1 switches whether to connect or disconnect the vertical signal line VSL and one end of the first capacitor C1. The second switch SW2 switches whether to connect the vertical signal line VSL to one end of the second capacitor C2 or to connect the output node of the sample and hold circuit 44. The third switch SW3 switches whether to connect the vertical signal line VSL to one end of the third capacitor C3 or to connect the output node of the sample and hold circuit 44.

The first switch SW1, the second switch SW2, and the third switch SW3 are switch-controlled by a control signal from an attenuation rate setting circuit 50. The attenuation rate setting circuit 50 generates a control signal for performing switching control of the first to third switches SW3 on the basis of the held signal of the latch circuit 42 and the second control signal CS2 from the logic circuit 14.

As described above, the column ADC 12 according to the fourth embodiment can variably control the attenuation rate of the pixel signal attenuated by the VSL attenuation circuit 18 according to an instruction from the logic circuit 14. Therefore, the attenuation rate of the pixel signal can be set more finely than the column ADC 12 in Figs. 5 and 15.

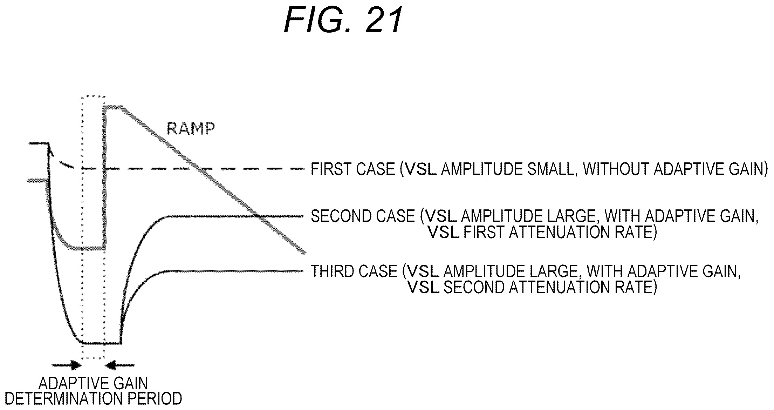

Fig. 21 is a signal waveform diagram of a pixel signal and a ramp signal attenuated by the VSL attenuation circuit 18 of Fig. 20. In the present embodiment, an adaptive gain determination period for determining whether the illuminance of light incident on the pixel 15 is higher than a predetermined reference illuminance is provided between a period (P-phase period) in which AD conversion is performed on a reset level signal and a period (D-phase period) in which AD conversion is performed on a pixel signal. In the example of Fig. 21, in the adaptive gain determination period, the attenuation of the pixel signal based on the second control signal CS2 from the logic circuit 14 is not performed, and after the adaptive gain determination period ends, the attenuation rate of the pixel signal based on the second control signal CS2 from the logic circuit 14 is set. The example of Fig. 21 includes a first case in which the pixel signal is not attenuated due to low illuminance, a second case in which the first attenuation rate based on the second control signal CS2 from the logic circuit 14 is set while adaptive attenuation of the pixel signal is performed due to high illuminance, and a third case in which the second attenuation rate based on the second control signal CS2 is set while adaptive attenuation of the pixel signal is performed due to high illuminance. The adaptive gain determination is performed using the comparator 41. That is, the comparator 41 functions as a determination section that determines an adaptive gain.

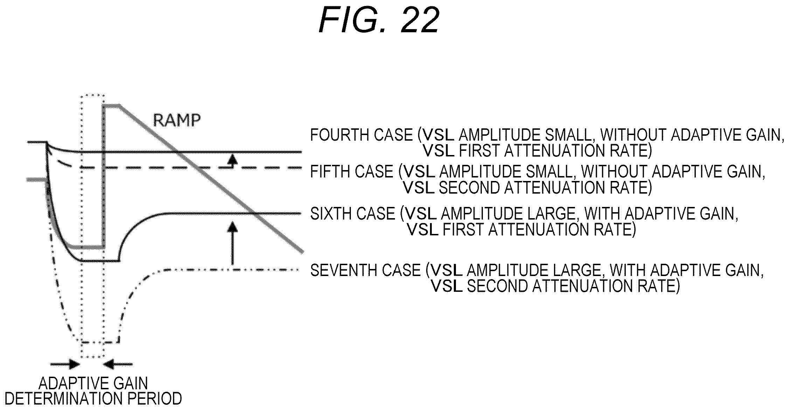

Fig. 22 is a signal waveform diagram illustrating a modification of Fig. 21. In Fig. 22, the attenuation rate of the pixel signal is set on the basis of the second control signal CS2 from the logic circuit 14 within the adaptive gain determination period. The example of Fig. 22 includes a fourth case in which the adaptive attenuation of the pixel signal is not performed due to low illuminance but the first attenuation rate based on the second control signal CS2 is set, a fifth case in which the adaptive attenuation of the pixel signal is not performed due to low illuminance but the second attenuation rate based on the second control signal CS2 is set, a sixth case in which the first attenuation rate based on the second control signal CS2 is set while the adaptive attenuation of the pixel signal is performed due to high illuminance, and a seventh case in which the second attenuation rate based on the second control signal CS2 is set while the adaptive attenuation of the pixel signal is performed due to high illuminance.

As described above, in the fourth embodiment, since not only the adaptive attenuation of the pixel signal based on the comparison result of the comparator 41 but also the attenuation rate of the pixel signal is set on the basis of the second control signal CS2 from the logic circuit 14, the attenuation rate of the pixel signal can be set more finely.

<Fifth embodiment>

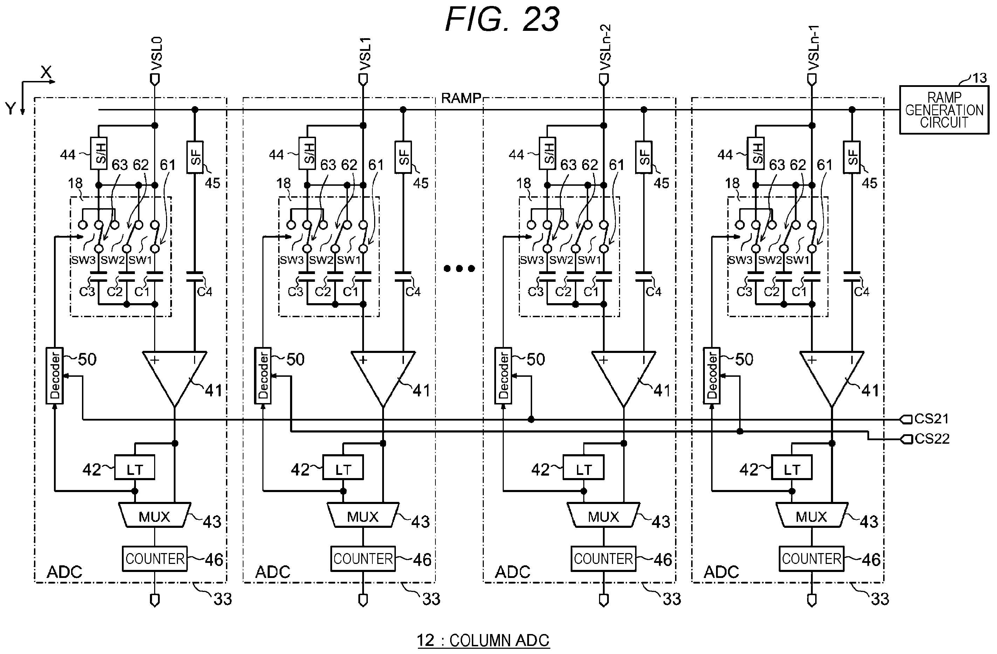

Fig. 23 is a block diagram illustrating a schematic configuration of a column ADC 12 included in a light detection element 1 according to a fifth embodiment. The column ADC 12 in Fig. 23 is characterized in that the attenuation rate of the pixel signal in the VSL attenuation circuit 18 can be varied for each ADC 33.

A logic circuit 14 supplies two types of second control signals CS21 and CS22 to the column ADC 12. In the example of Fig. 23, different second control signals CS21 and CS22 are supplied to two ADCs 33 adjacent in the first direction X. Therefore, in the two ADCs 33 adjacent to each other in the first direction X, attenuation rates different from each other can be set in the pixel signal.

Note that the column ADC 12 in Fig. 23 can take various modifications. For example, the logic circuit 14 may supply three or more types of the second control signals CS2 to the column ADC 12. Which of the plurality of ADCs 33 the plurality of types of second control signals CS2 is allocated to is arbitrary.

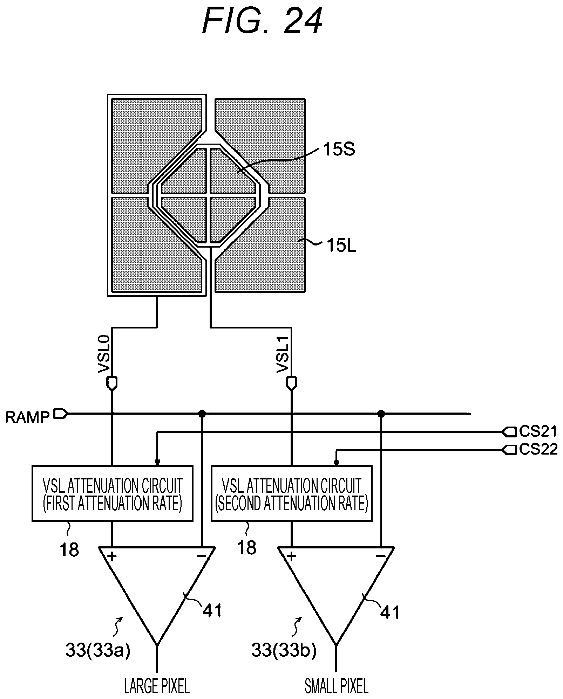

Fig. 24 is a block diagram of a column ADC 12 illustrating a first specific example of the fifth embodiment. The column ADC 12 in Fig. 24 includes a first ADC 33a that performs AD conversion on the pixel signal from the large pixel 15L and a second ADC 33b that performs AD conversion on the pixel signal from the small pixel 15S. Different second control signals CS21 and CS22 from the logic circuit 14 are supplied to the first ADC 33a and the second ADC 33b, respectively. Since the signal level of the large pixel 15L greatly changes, the attenuation rate (first attenuation rate) of the VSL attenuation circuit 18 in the ADC 33a for the large pixel 15L is set to be larger than the attenuation rate (second attenuation rate) of the VSL attenuation circuit 18 in the ADC 33b for the small pixel 15S.

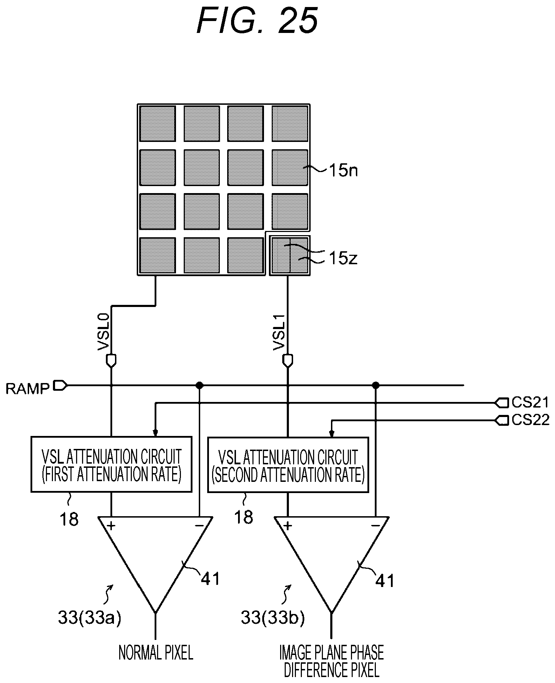

Fig. 25 is a block diagram of a column ADC 12 illustrating a second specific example of the fifth embodiment. The column ADC 12 in Fig. 25 includes a first ADC 33a that performs AD conversion on the pixel signal from the normal pixel 15n and a second ADC 33b that performs AD conversion on the pixel signal from the image plane phase difference pixel 15z. The first ADC 33a and the second ADC 33b are supplied with different second control signals CS2 from the logic circuit 14. Since the image plane phase difference pixel 15z has a signal level lower than that of the normal pixel 15n, the attenuation rate (second attenuation rate) of the VSL attenuation circuit 18 in the ADC 33b for the image plane phase difference pixel 15z is set smaller than the attenuation rate (first attenuation rate) of the VSL attenuation circuit 18 in the ADC 33a for the normal pixel 15n.

As described above, according to the fifth embodiment, the attenuation rates of the pixel signals input to the plurality of ADCs 33 can be made different from each other.

<Sixth embodiment>

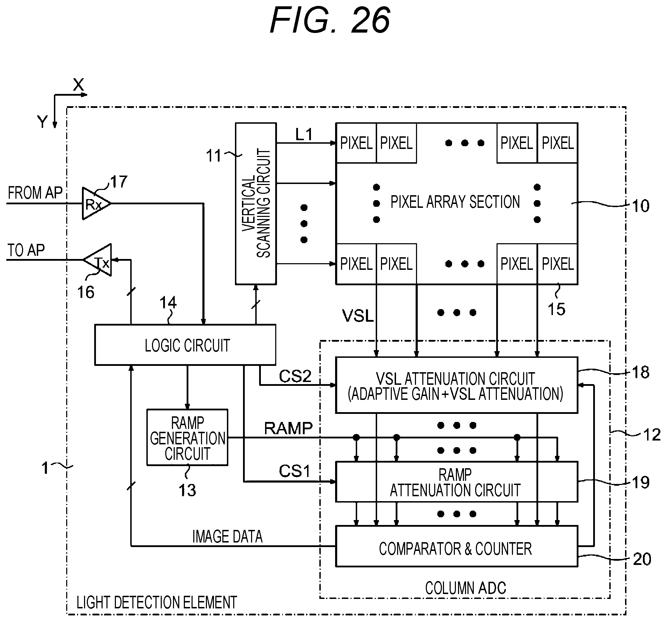

Fig. 26 is a block diagram illustrating a schematic configuration of a light detection element 1 according to a sixth embodiment. An imaging device 2 including the light detection element 1 according to the sixth embodiment has a block configuration similar to that in Fig. 1. Hereinafter, differences from the light detection element 1 according to the first embodiment will be mainly described.

The light detection element 1 in Fig. 26 is characterized in that the column ADC 12 in the light detection element 1 in Fig. 19 has the same configuration as the column ADC 12 in Fig. 2. That is, a column ADC 12 in Fig. 26 includes a VSL attenuation circuit 18, a ramp attenuation circuit 19, and a comparator & counter 20. A logic circuit 14 supplies a first control signal CS1 and a second control signal CS2 to the column ADC 12. Other configurations of the light detection element 1 of Fig. 26 are the same as those of the light detection element 1 of Fig. 19.

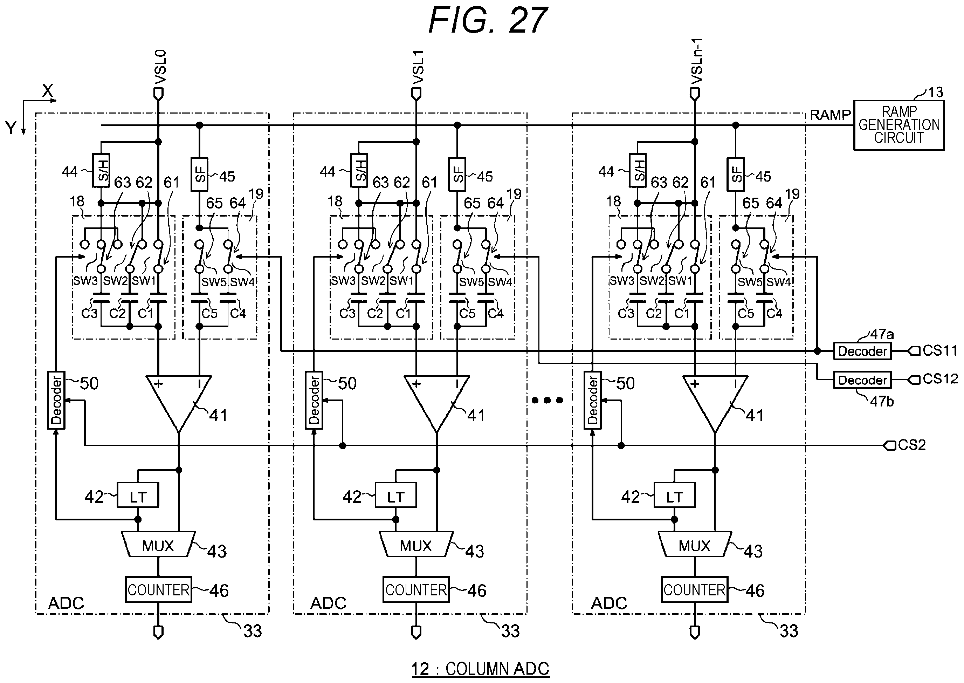

Fig. 27 is a block diagram illustrating an internal configuration of a column ADC 12 according to the sixth embodiment. Each ADC 33 of the column ADC 12 in Fig. 27 includes a comparator 41, a latch circuit 42, a multiplexer 43, a sample and hold circuit 44, a VSL attenuation circuit 18, a source follower circuit 45, and a ramp attenuation circuit 19. That is, the ADC 33 of Fig. 27 has a configuration in which the ramp attenuation circuit 19 is added to the ADC 33 of Fig. 19.

The ramp attenuation circuit 19 of Fig. 27 is configured similarly to the ramp attenuation circuit 19 of Fig. 5. The attenuation rate of the ramp attenuation circuit 19 of each ADC 33 is set on the basis of the first control signals CS11 and CS12 from the logic circuit 14.

The VSL attenuation circuit 18 of Fig. 27 is configured similarly to the VSL attenuation circuit 18 of Fig. 20. The attenuation rate of the VSL attenuation circuit 18 of each ADC 33 is set on the basis of the second control signal CS2 from the logic circuit 14.

The light detection element 1 according to the sixth embodiment can perform binning processing of adding the pixel signals of the plurality of pixels 15 and then performing AD conversion.

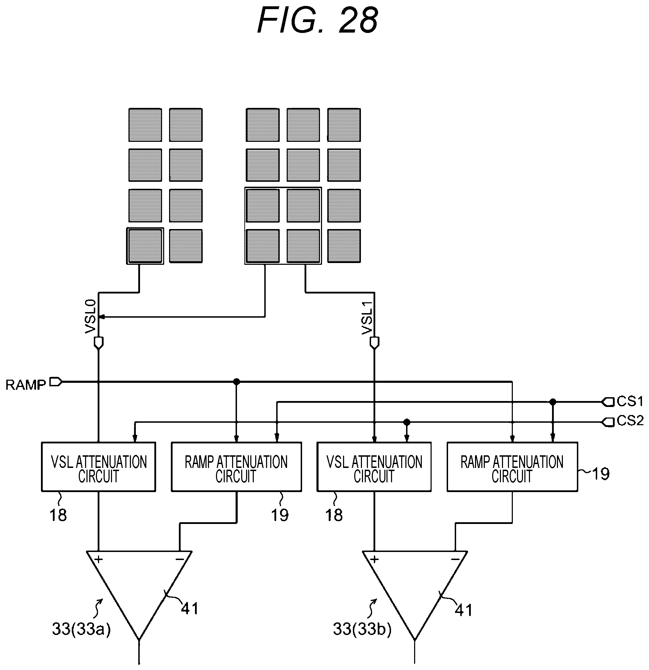

Fig. 28 is a block diagram illustrating a schematic configuration of the column ADC 12 corresponding to the binning processing. In the vertical signal line VSL connected to at least some of the ADCs 33 in the column ADC 12, the pixel signals of the plurality of pixel columns are added. Therefore, the ADC 33a performs AD conversion processing on the signal obtained by adding the pixel signals of the plurality of pixels 15. Since the change in the signal level increases when the pixel signals are added, the adaptive attenuation of the pixel signal and the attenuation rate based on the second control signal CS2 are set, and the attenuation rate of the ramp signal based on the first control signal CS1 is set. In Fig. 28, the ADC 33b that performs AD conversion without adding the pixel signals of the plurality of pixels 15 is provided, but it is arbitrary whether or not both or any one of the ADC 33a and the ADC 33b is provided.

As described above, in the sixth embodiment, the adaptive attenuation of the pixel signal and the attenuation rate of the pixel signal based on the second control signal CS2 are set, and the attenuation rate of the ramp signal based on the first control signal CS1 is set. Therefore, horizontal streak noise can be reduced.

<Seventh embodiment>

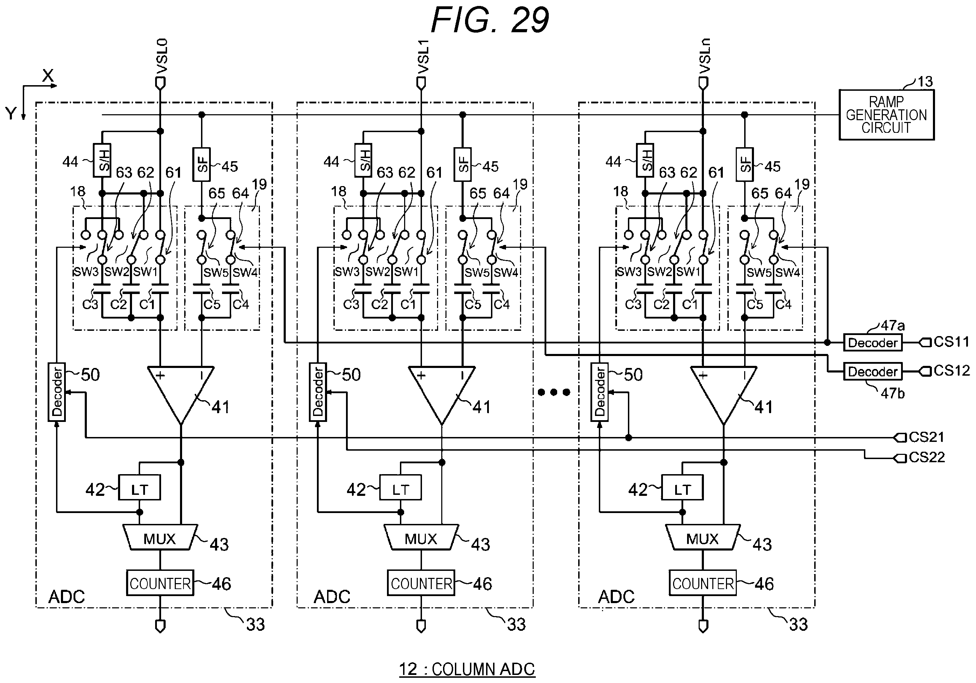

Fig. 29 is a block diagram illustrating a schematic configuration of a column ADC 12 included in a light detection element 1 according to a seventh embodiment. The column ADC 12 in Fig. 29 is characterized in that the attenuation rate of a pixel signal in a VSL attenuation circuit 18 and the attenuation rate of a ramp signal in a ramp attenuation circuit 19 can be varied for each ADC 33.

Each ADC 33 in the column ADC 12 of Fig. 29 includes the VSL attenuation circuit 18 having a configuration similar to that of the ADC 33 of Fig. 28. Each VSL attenuation circuit 18 can perform adaptive attenuation of the pixel signal and set an attenuation rate of the pixel signal on the basis of the second control signals CS21 and CS22.

Furthermore, among the ADCs 33 in Fig. 29, the odd-numbered ADC 33 and the even-numbered ADC 33 arranged in the first direction X set the attenuation rate of the ramp signal on the basis of the first control signals CS11 and CS12 different from each other. Note that although the two types of first control signals CS11 and CS12 are supplied from a logic circuit 14 to the column ADC 12 in Fig. 29, three or more types of first control signals CS1 may be supplied. How to allocate the plurality of types of first control signals CS1 to the plurality of ADCs 33 is arbitrary.

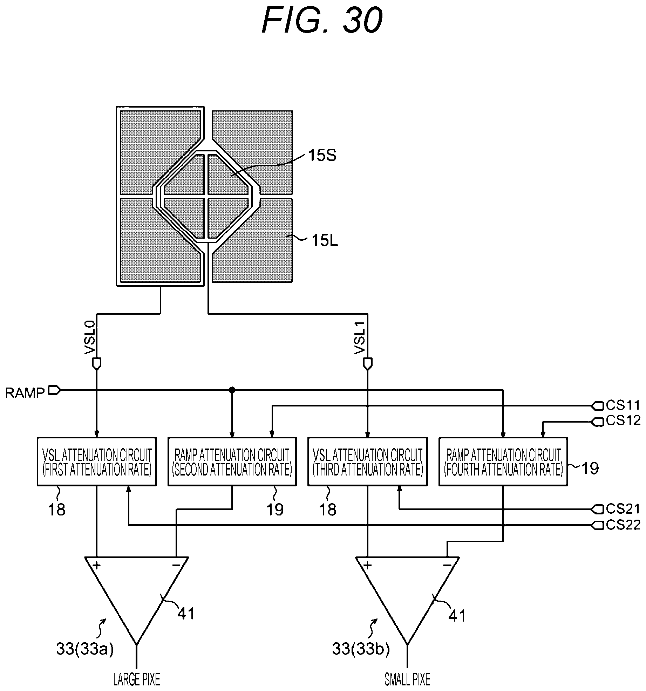

Fig. 30 is a block diagram of a column ADC 12 according to a first specific example of the seventh embodiment. The column ADC 12 in Fig. 30 includes a first ADC 33a that performs AD conversion on the pixel signal from the large pixel 15L and a second ADC 33b that performs AD conversion on the pixel signal from the small pixel 15S.

Since the signal level of the pixel signal from the large pixel 15L changes more greatly than the signal level of the pixel signal from the small pixel 15S, a VSL attenuation circuit 18 in the first ADC 33a sets the attenuation rate (first attenuation rate) of the pixel signal from the large pixel 15L to be larger than the attenuation rate (third attenuation rate) of the pixel signal from the small pixel 15S, and a ramp attenuation circuit 19 sets the attenuation rate (second attenuation rate) of the ramp attenuation circuit 19 for the large pixel 15L to be smaller than the attenuation rate (fourth attenuation rate) of the ramp attenuation circuit 19 for the small pixel 15S.

In the first specific example of the seventh embodiment in Fig. 30, several combinations of settings of the first to fourth attenuation rates are conceivable. As one example of setting the attenuation rates, since the signal level of the pixel signal from the large pixel 15L changes more greatly than the signal level of the pixel signal from the small pixel 15S, the VSL attenuation circuit 18 in the first ADC 33a can set the attenuation rate (first attenuation rate) of the pixel signal from the large pixel 15L to be larger than the attenuation rate (third attenuation rate) of the pixel signal from the small pixel 15S. In this case, the ramp attenuation circuit 19 sets the attenuation rate (second attenuation rate) of the ramp attenuation circuit 19 for the large pixel 15L to be smaller than the attenuation rate (fourth attenuation rate) of the ramp attenuation circuit 19 for the small pixel 15S.

Furthermore, as another setting example of the attenuation rates, the attenuation rate (first attenuation rate) of the pixel signal from the large pixel 15L and the attenuation rate (third attenuation rate) of the pixel signal from the small pixel 15S can be made the same. In this case, the ramp attenuation circuit 19 sets the attenuation rate (fourth attenuation rate) of the ramp attenuation circuit 19 for the small pixel 15S to be larger than the attenuation rate (second attenuation rate) of the ramp attenuation circuit 19 for the large pixel 15L.

Note that the setting of the attenuation rates is not necessarily limited to the above-described example, and in the seventh embodiment, the attenuation rates of both the VSL attenuation circuit 18 and the ramp attenuation circuit 19 can be set, so that the attenuation rates can be flexibly set depending on the purpose.

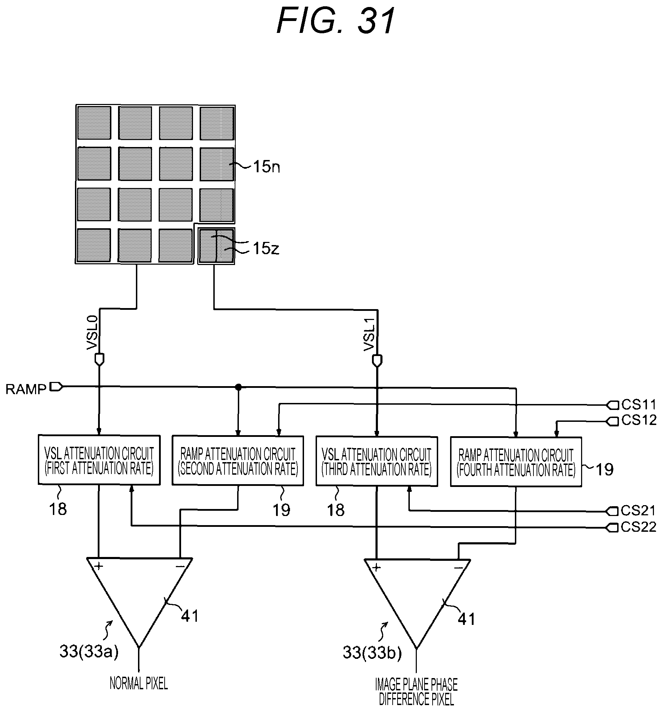

Fig. 31 is a block diagram of a column ADC 12 according to a second specific example of the seventh embodiment. The column ADC 12 in Fig. 31 includes a first ADC 33a that performs AD conversion on the pixel signal from the normal pixel 15n and a second ADC 33b that performs AD conversion on the pixel signal from the image plane phase difference pixel 15z.

Since the pixel signal from the image plane phase difference pixel 15z has a signal level smaller than that of the pixel signal from the normal pixel 15n, the attenuation rate (first attenuation rate) of a VSL attenuation circuit 18 in the second ADC 33b is set smaller than the attenuation rate (third attenuation rate) of the pixel signal from the image plane phase difference pixel 15z, and the attenuation rate (second attenuation rate) of a ramp attenuation circuit 19 for the normal pixel 15n is set smaller than the attenuation rate (fourth attenuation rate) of the ramp attenuation circuit 19 for the image plane phase difference pixel 15z.

In the second specific example of the seventh embodiment in Fig. 31, several combinations of settings of the first to fourth attenuation rates are conceivable. As one example of setting the attenuation rates, since the signal level of the pixel signal from the normal pixel 15n changes more greatly than the signal level of the pixel signal from the image plane phase difference pixel 15z, the VSL attenuation circuit 18 in the first ADC 33a can set the attenuation rate (first attenuation rate) of the pixel signal from the normal pixel 15n to be larger than the attenuation rate (third attenuation rate) of the pixel signal from the image plane phase difference pixel 15z. In this case, the ramp attenuation circuit 19 sets the attenuation rate (second attenuation rate) of the ramp attenuation circuit 19 for the large pixel 15L to be smaller than the attenuation rate (fourth attenuation rate) of the ramp attenuation circuit 19 for the image plane phase difference pixel 15z.

Furthermore, as another setting example of the attenuation rates, the attenuation rate (first attenuation rate) of the pixel signal from the normal pixel 15n and the attenuation rate (third attenuation rate) of the pixel signal from the image plane phase difference pixel 15z can be made the same. In this case, the ramp attenuation circuit 19 sets the attenuation rate (fourth attenuation rate) of the ramp attenuation circuit 19 for the image plane phase difference pixel 15z to be larger than the attenuation rate (second attenuation rate) of the ramp attenuation circuit 19 for the large pixel 15L.

Note that the setting of the attenuation rates is not necessarily limited to the above-described example, and in the seventh embodiment, the attenuation rates of both the VSL attenuation circuit 18 and the ramp attenuation circuit 19 can be set, so that the attenuation rates can be flexibly set depending on the purpose.

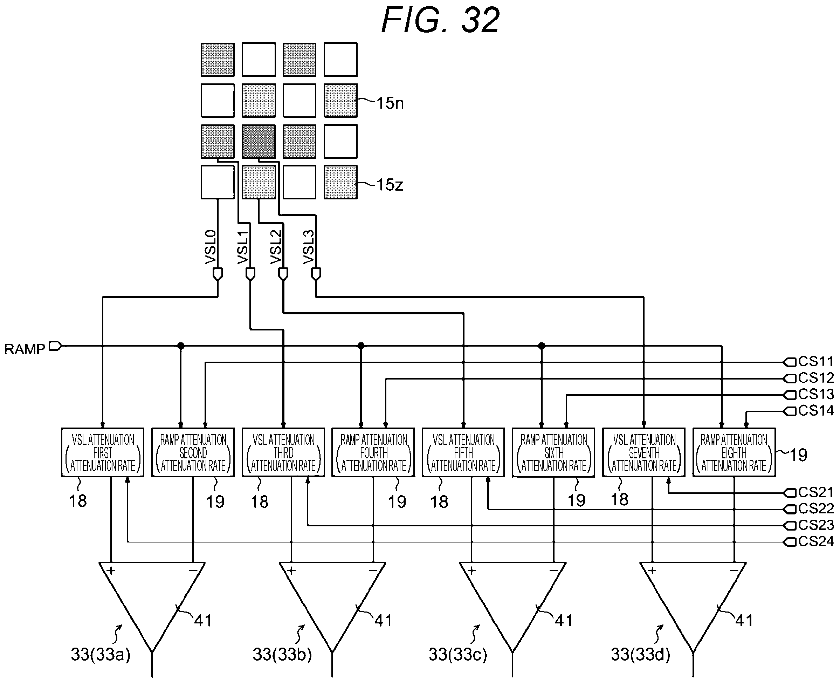

Fig. 32 is a block diagram of a column ADC 12 according to a third specific example of the seventh embodiment. The column ADC 12 in Fig. 32 includes a first ADC 33a that performs AD conversion on the pixel signal from the red pixel 15, a second ADC 33b that performs AD conversion on the pixel signal from the green pixel 15, a third ADC 33 that performs AD conversion on the pixel signal from the blue pixel 15, and a fourth ADC 33 that performs AD conversion on the pixel signal from the white pixel 15.

Since the signal level of the pixel signal may be different for each color, the VSL attenuation circuit 18 performs optimal adaptive attenuation for each color on the basis of the second control signals CS21 to CS24 and sets an optimal attenuation rate (first, third, fifth, and seventh attenuation rates). Similarly, the ramp attenuation circuit 19 sets an optimal attenuation rate (second, fourth, sixth, and eighth attenuation rates) for each color on the basis of the first control signals CS11 to CS14.

As described above, in the seventh embodiment, since the attenuation rate of the pixel signal and the ramp signal can be set for each ADC 33 in the column ADC 12, even in a case where a plurality of pixels 15 having different photoelectric conversion characteristics is mixed, the horizontal streak noise can be reduced.

(Application example)

The technology according to the present disclosure can be applied to various products. For example, the technology according to the present disclosure may also be implemented as a device mounted on any type of mobile body such as an automobile, an electric automobile, a hybrid electric automobile, a motorcycle, a bicycle, a personal mobility, an airplane, a drone, a ship, a robot, a construction machine, or an agricultural machine (tractor).

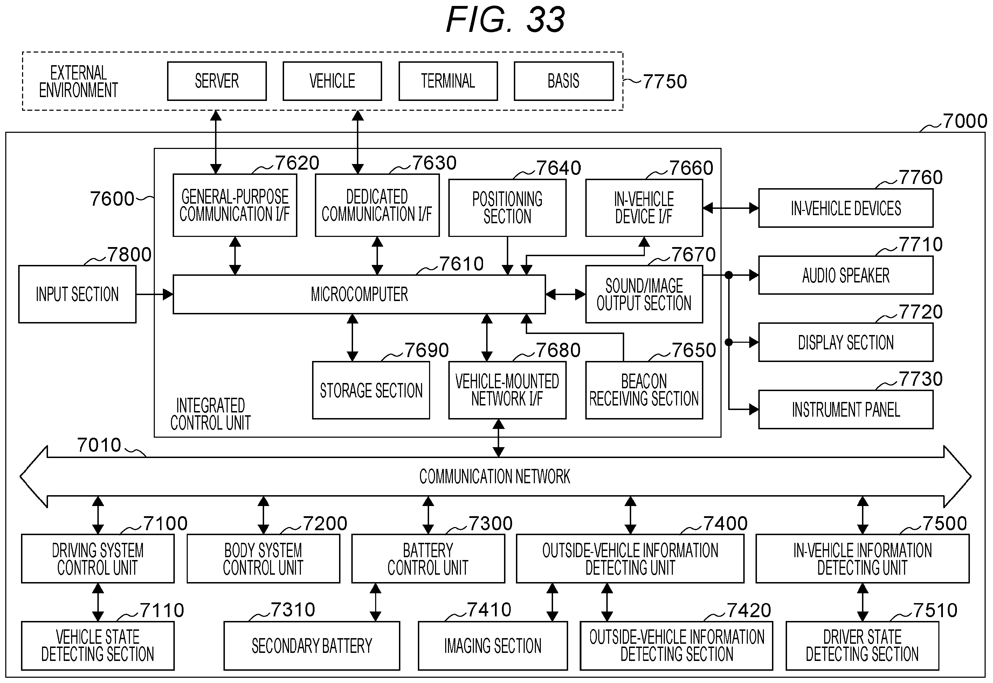

Fig. 33 is a block diagram illustrating a schematic configuration example of a vehicle control system 7000 as an example of a mobile body to which the technology according to the present disclosure can be applied. The vehicle control system 7000 includes a plurality of electronic control units connected to each other via a communication network 7010. In the example illustrated in Fig. 33, the vehicle control system 7000 includes a driving system control unit 7100, a body system control unit 7200, a battery control unit 7300, an outside-vehicle information detecting unit 7400, an in-vehicle information detecting unit 7500, and an integrated control unit 7600. The communication network 7010 connecting the plurality of control units to each other may, for example, be a vehicle-mounted communication network compliant with an arbitrary standard such as controller area network (CAN), local interconnect network (LIN), local area network (LAN), FlexRay (registered trademark), or the like.

Each of the control units includes: a microcomputer that performs arithmetic processing according to various kinds of programs; a storage section that stores the programs executed by the microcomputer, parameters used for various kinds of operations, or the like; and a driving circuit that drives various kinds of control target devices. Each of the control units further includes: a network interface (I/F) for performing communication with other control units via the communication network 7010; and a communication I/F for performing communication with a device, a sensor, or the like within and without the vehicle by wire communication or radio communication. In Fig. 33, a microcomputer 7610, a general-purpose communication I/F 7620, a dedicated communication I/F 7630, a positioning section 7640, a beacon receiving section 7650, an in-vehicle device I/F 7660, a sound/image output section 7670, a vehicle-mounted network I/F 7680, and a storage section 7690 are illustrated as a functional configuration of the integrated control unit 7600. The other control units similarly include a microcomputer, a communication I/F, a storage section, and the like.

The driving system control unit 7100 controls the operation of devices related to the driving system of the vehicle in accordance with various kinds of programs. For example, the driving system control unit 7100 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like. The driving system control unit 7100 may have a function as a control device of an antilock brake system (ABS), electronic stability control (ESC), or the like.

The driving system control unit 7100 is connected with a vehicle state detecting section 7110. The vehicle state detecting section 7110, for example, includes at least one of a gyro sensor that detects the angular velocity of axial rotational movement of a vehicle body, an acceleration sensor that detects the acceleration of the vehicle, and sensors for detecting an amount of operation of an accelerator pedal, an amount of operation of a brake pedal, the steering angle of a steering wheel, an engine speed or the rotational speed of wheels, and the like. The driving system control unit 7100 performs arithmetic processing using a signal input from the vehicle state detecting section 7110, and controls the internal combustion engine, the driving motor, an electric power steering device, the brake device, and the like.

The body system control unit 7200 controls the operation of various kinds of devices provided to the vehicle body in accordance with various kinds of programs. For example, the body system control unit 7200 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 7200. The body system control unit 7200 receives these input radio waves or signals, and controls a door lock device, the power window device, the lamps, or the like of the vehicle.

The battery control unit 7300 controls a secondary battery 7310, which is a power supply source for the driving motor, in accordance with various kinds of programs. For example, the battery control unit 7300 is supplied with information about a battery temperature, a battery output voltage, an amount of charge remaining in the battery, or the like from a battery device including the secondary battery 7310. The battery control unit 7300 performs arithmetic processing using these signals, and performs control for regulating the temperature of the secondary battery 7310 or controls a cooling device provided to the battery device or the like.

The outside-vehicle information detecting unit 7400 detects information about the outside of the vehicle including the vehicle control system 7000. For example, the outside-vehicle information detecting unit 7400 is connected with at least one of an imaging section 7410 and an outside-vehicle information detecting section 7420. The imaging section 7410 includes at least one of a time-of-flight (ToF) camera, a stereo camera, a monocular camera, an infrared camera, and other cameras. The outside-vehicle information detecting section 7420, for example, includes at least one of an environmental sensor for detecting current atmospheric conditions or weather conditions and a peripheral information detecting sensor for detecting another vehicle, an obstacle, a pedestrian, or the like on the periphery of the vehicle including the vehicle control system 7000.

The environmental sensor, for example, may be at least one of a rain drop sensor detecting rain, a fog sensor detecting a fog, a sunshine sensor detecting a degree of sunshine, and a snow sensor detecting a snowfall. The peripheral information detecting sensor may be at least one of an ultrasonic sensor, a radar device, and a LIDAR device (Light detection and Ranging device, or Laser imaging detection and ranging device). Each of the imaging section 7410 and the outside-vehicle information detecting section 7420 may be provided as an independent sensor or device, or may be provided as a device in which a plurality of sensors or devices are integrated.

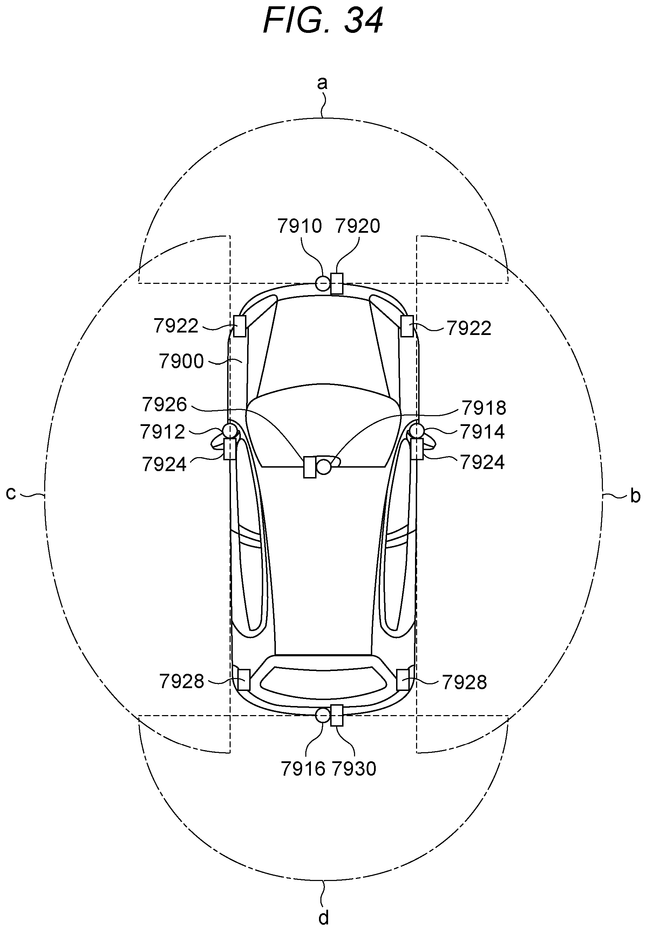

Here, Fig. 34 illustrates an example of installation positions of the imaging section 7410 and the outside-vehicle information detecting section 7420. Imaging sections 7910, 7912, 7914, 7916, and 7918 are, for example, disposed at at least one of positions on a front nose, sideview mirrors, a rear bumper, and a back door of the vehicle 7900 and a position on an upper portion of a windshield within the interior of the vehicle. The imaging section 7910 provided to the front nose and the imaging section 7918 provided to the upper portion of the windshield within the interior of the vehicle obtain mainly an image of the front of the vehicle 7900. The imaging sections 7912 and 7914 provided to the sideview mirrors obtain mainly an image of the sides of the vehicle 7900. The imaging section 7916 provided to the rear bumper or the back door obtains mainly an image of the rear of the vehicle 7900. The imaging section 7918 provided to the upper portion of the windshield within the interior of the vehicle is used mainly to detect a preceding vehicle, a pedestrian, an obstacle, a signal, a traffic sign, a lane, or the like.

Note that Fig. 34 illustrates an example of the imaging range of each of the imaging sections 7910, 7912, 7914, and 7916. An imaging range a represents the imaging range of the imaging section 7910 provided to the front nose. Imaging ranges b and c respectively represent the imaging ranges of the imaging sections 7912 and 7914 provided to the sideview mirrors. An imaging range d represents the imaging range of the imaging section 7916 provided to the rear bumper or the back door. A bird's-eye image of the vehicle 7900 as viewed from above can be obtained by superimposing image data imaged by the imaging sections 7910, 7912, 7914, and 7916, for example.

Outside-vehicle information detecting sections 7920, 7922, 7924, 7926, 7928, and 7930 provided to the front, rear, sides, and corners of the vehicle 7900 and the upper portion of the windshield within the interior of the vehicle may be, for example, an ultrasonic sensor or a radar device. The outside-vehicle information detecting sections 7920, 7926, and 7930 provided to the front nose of the vehicle 7900, the rear bumper, the back door of the vehicle 7900, and the upper portion of the windshield within the interior of the vehicle may be a LIDAR device, for example. These outside-vehicle information detecting sections 7920 to 7930 are used mainly to detect a preceding vehicle, a pedestrian, an obstacle, or the like.

Referring back to Fig. 33, the description will be continued. The outside-vehicle information detecting unit 7400 makes the imaging section 7410 image an image of the outside of the vehicle, and receives imaged image data. In addition, the outside-vehicle information detecting unit 7400 receives detection information from the outside-vehicle information detecting section 7420 connected to the outside-vehicle information detecting unit 7400. In a case where the outside-vehicle information detecting section 7420 is an ultrasonic sensor, a radar device, or a LIDAR device, the outside-vehicle information detecting unit 7400 transmits an ultrasonic wave, an electromagnetic wave, or the like, and receives information of a received reflected wave. On the basis of the received information, the outside-vehicle information detecting unit 7400 may perform processing of detecting an object such as a human, a vehicle, an obstacle, a sign, a character on a road surface, or the like, or processing of detecting a distance thereto. The outside-vehicle information detecting unit 7400 may perform environment recognition processing of recognizing a rainfall, a fog, road surface conditions, or the like on the basis of the received information. The outside-vehicle information detecting unit 7400 may calculate a distance to an object outside the vehicle on the basis of the received information.

In addition, on the basis of the received image data, the outside-vehicle information detecting unit 7400 may perform image recognition processing of recognizing a human, a vehicle, an obstacle, a sign, a character on a road surface, or the like, or processing of detecting a distance thereto. The outside-vehicle information detecting unit 7400 may subject the received image data to processing such as distortion correction, alignment, or the like, and combine the image data imaged by a plurality of different imaging sections 7410 to generate a bird's-eye image or a panoramic image. The outside-vehicle information detecting unit 7400 may perform viewpoint conversion processing using the image data imaged by the imaging section 7410 including the different imaging parts.

The in-vehicle information detecting unit 7500 detects information about the inside of the vehicle. The in-vehicle information detecting unit 7500 is, for example, connected with a driver state detecting section 7510 that detects the state of a driver. The driver state detecting section 7510 may include a camera that images the driver, a biosensor that detects biological information of the driver, a microphone that collects sound within the interior of the vehicle, or the like. The biosensor is, for example, disposed in a seat surface, the steering wheel, or the like, and detects biological information of an occupant sitting in a seat or the driver holding the steering wheel. On the basis of detection information input from the driver state detecting section 7510, the in-vehicle information detecting unit 7500 may calculate a degree of fatigue of the driver or a degree of concentration of the driver, or may determine whether the driver is dozing. The in-vehicle information detecting unit 7500 may subject an audio signal obtained by the collection of the sound to processing such as noise canceling processing or the like.

The integrated control unit 7600 controls general operation within the vehicle control system 7000 in accordance with various kinds of programs. The integrated control unit 7600 is connected with an input section 7800. The input section 7800 is implemented by a device capable of input operation by an occupant, such, for example, as a touch panel, a button, a microphone, a switch, a lever, or the like. The integrated control unit 7600 may be supplied with data obtained by voice recognition of voice input through the microphone. The input section 7800 may, for example, be a remote control device using infrared rays or other radio waves, or an external connecting device such as a mobile telephone, a personal digital assistant (PDA), or the like that supports operation of the vehicle control system 7000. The input section 7800 may be, for example, a camera. In that case, an occupant can input information by gesture. Alternatively, data may be input which is obtained by detecting the movement of a wearable device that an occupant wears. Further, the input section 7800 may, for example, include an input control circuit or the like that generates an input signal on the basis of information input by an occupant or the like using the above-described input section 7800, and which outputs the generated input signal to the integrated control unit 7600. An occupant or the like inputs various kinds of data or gives an instruction for processing operation to the vehicle control system 7000 by operating the input section 7800.

The storage section 7690 may include a read only memory (ROM) that stores various kinds of programs executed by the microcomputer and a random access memory (RAM) that stores various kinds of parameters, operation results, sensor values, or the like. In addition, the storage section 7690 may be implemented by a magnetic storage device such as a hard disc drive (HDD) or the like, a semiconductor storage device, an optical storage device, a magnetooptical storage device, or the like.

The general-purpose communication I/F 7620 is a communication I/F used widely, which communication I/F mediates communication with various apparatuses present in an external environment 7750. The general-purpose communication I/F 7620 may implement a cellular communication protocol such as global system for mobile communications (GSM (registered trademark)), worldwide interoperability for microwave access (WiMAX (registered trademark)), long term evolution (LTE (registered trademark)), LTE-advanced (LTE-A), or the like, or another wireless communication protocol such as wireless LAN (referred to also as wireless fidelity (Wi-Fi (registered trademark)), Bluetooth (registered trademark), or the like. The general-purpose communication I/F 7620 may, for example, connect to an apparatus (for example, an application server or a control server) present on an external network (for example, the Internet, a cloud network, or a company-specific network) via a base station or an access point. In addition, the general-purpose communication I/F 7620 may connect to a terminal present in the vicinity of the vehicle (which terminal is, for example, a terminal of the driver, a pedestrian, or a store, or a machine type communication (MTC) terminal) using a peer to peer (P2P) technology, for example.

The dedicated communication I/F 7630 is a communication I/F that supports a communication protocol developed for use in vehicles. The dedicated communication I/F 7630 may implement a standard protocol such, for example, as wireless access in vehicle environment (WAVE), which is a combination of institute of electrical and electronic engineers (IEEE) 802.11p as a lower layer and IEEE 1609 as a higher layer, dedicated short range communications (DSRC), or a cellular communication protocol. The dedicated communication I/F 7630 typically carries out V2X communication as a concept including one or more of communication between a vehicle and a vehicle (Vehicle to Vehicle), communication between a road and a vehicle (Vehicle to Infrastructure), communication between a vehicle and a home (Vehicle to Home), and communication between a pedestrian and a vehicle (Vehicle to Pedestrian).

The positioning section 7640, for example, performs positioning by receiving a global navigation satellite system (GNSS) signal from a GNSS satellite (for example, a GPS signal from a global positioning system (GPS) satellite), and generates positional information including the latitude, longitude, and altitude of the vehicle. Incidentally, the positioning section 7640 may identify a current position by exchanging signals with a wireless access point, or may obtain the positional information from a terminal such as a mobile telephone, a personal handyphone system (PHS), or a smart phone that has a positioning function.

The beacon receiving section 7650, for example, receives a radio wave or an electromagnetic wave transmitted from a radio station installed on a road or the like, and thereby obtains information about the current position, congestion, a closed road, a necessary time, or the like. Incidentally, the function of the beacon receiving section 7650 may be included in the dedicated communication I/F 7630 described above.

The in-vehicle device I/F 7660 is a communication interface that mediates connection between the microcomputer 7610 and various in-vehicle devices 7760 present within the vehicle. The in-vehicle device I/F 7660 may establish wireless connection using a wireless communication protocol such as wireless LAN, Bluetooth (registered trademark), near field communication (NFC), or wireless universal serial bus (WUSB). In addition, the in-vehicle device I/F 7660 may establish wired connection by universal serial bus (USB), high-definition multimedia interface (HDMI (registered trademark)), mobile high-definition link (MHL), or the like via a connection terminal (and a cable if necessary) not depicted in the figures. The in-vehicle devices 7760 may, for example, include at least one of a mobile device and a wearable device possessed by an occupant and an information device carried into or attached to the vehicle. The in-vehicle devices 7760 may also include a navigation device that searches for a path to an arbitrary destination. The in-vehicle device I/F 7660 exchanges control signals or data signals with these in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various kinds of programs on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. For example, the microcomputer 7610 may calculate a control target value for the driving force generating device, the steering mechanism, or the braking device on the basis of the obtained information about the inside and outside of the vehicle, and output a control command to the driving system control unit 7100. For example, the microcomputer 7610 may perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like. In addition, the microcomputer 7610 may perform cooperative control intended for automated driving, which makes the vehicle to travel automatedly without depending on the operation of the driver, or the like, by controlling the driving force generating device, the steering mechanism, the braking device, or the like on the basis of the obtained information about the surroundings of the vehicle.

The microcomputer 7610 may generate three-dimensional distance information between the vehicle and an object such as a surrounding structure, a person, or the like, and generate local map information including information about the surroundings of the current position of the vehicle, on the basis of information obtained via at least one of the general-purpose communication I/F 7620, the dedicated communication I/F 7630, the positioning section 7640, the beacon receiving section 7650, the in-vehicle device I/F 7660, and the vehicle-mounted network I/F 7680. In addition, the microcomputer 7610 may predict danger such as collision of the vehicle, approaching of a pedestrian or the like, an entry to a closed road, or the like on the basis of the obtained information, and generate a warning signal. The warning signal may, for example, be a signal for producing a warning sound or lighting a warning lamp.

The sound/image output section 7670 transmits an output signal of at least one of a sound and an image to an output device capable of visually or auditorily notifying information to an occupant of the vehicle or the outside of the vehicle. In the example of Fig. 33, an audio speaker 7710, a display section 7720, and an instrument panel 7730 are illustrated as the output device. The display section 7720 may, for example, include at least one of an on-board display and a head-up display. The display section 7720 may have an augmented reality (AR) display function. The output device may be other than these devices, and may be another device such as headphones, a wearable device such as an eyeglass type display worn by an occupant or the like, a projector, a lamp, or the like. In a case where the output device is a display device, the display device visually displays results obtained by various kinds of processing performed by the microcomputer 7610 or information received from another control unit in various forms such as text, an image, a table, a graph, or the like. In addition, in a case where the output device is an audio output device, the audio output device converts an audio signal constituted of reproduced audio data or sound data or the like into an analog signal, and auditorily outputs the analog signal.

Note that, in the example illustrated in Fig. 33, at least two control units connected through the communication network 7010 may be integrated as one control unit. Alternatively, each individual control unit may include a plurality of control units. Further, the vehicle control system 7000 may include another control unit not depicted in the figures. In addition, part or the whole of the functions performed by one of the control units in the above description may be assigned to another control unit. That is, predetermined arithmetic processing may be performed by any of the control units as long as information is transmitted and received via the communication network 7010. Similarly, a sensor or a device connected to one of the control units may be connected to another control unit, and a plurality of control units may mutually transmit and receive detection information via the communication network 7010.

Note that the present technology may have the following configurations.

    (1) A light detection element including:

        a first attenuation circuit that attenuates an input signal at any of a plurality of attenuation rates according to a signal level and outputs an output signal;
        a second attenuation circuit that attenuates a reference signal at an attenuation rate according to a control signal and outputs an output signal;
        a first comparator that compares the output signal of the first attenuation circuit with the output signal of the second attenuation circuit; and
        a first counter that generates a digital signal according to the input signal on the basis of a comparison result of the first comparator.

(2) The light detection element according to (1), in which
the second attenuation circuit attenuates the reference signal at an attenuation rate according to the control signal and outputs an output signal before the first comparator starts a comparison operation.

(3) The light detection element according to (1) or (2), in which
the first attenuation circuit determines an attenuation rate according to a signal level of the input signal after an attenuation rate of the second attenuation circuit is determined.

(4) The light detection element according to any one of (1) to (3), further including:

a reference signal line that transmits the reference signal; and
a source follower circuit connected to the reference signal line,
in which the second attenuation circuit includes:

a first switch and a first capacitor connected in series between an output node of the source follower circuit and a first input terminal of the first comparator; and
a second switch and a second capacitor connected in series between the output node of the source follower circuit and the first input terminal of the first comparator, and
the first switch and the second switch are switch-controlled by the control signal.

(5) The light detection element according to (4), in which
the second attenuation circuit performs switching control of the first switch and the second switch on the basis of the control signal such that the reference signal is attenuated at an attenuation rate according to a capacitance ratio between the first capacitor and the second capacitor.

(6) The light detection element according to (5), further including
a logic circuit that generates the control signal for performing switching control of the first switch and the second switch according to illuminance of light incident on a target pixel.

(7) The light detection element according to any one of (1) to (6), further including:

a third attenuation circuit that attenuates an input signal at any of a plurality of attenuation rates according to a signal level and outputs an output signal;
a second comparator that compares the output signal of the third attenuation circuit with a reference signal having a fixed signal level; and
a second counter that generates a digital signal according to the input signal on the basis of a comparison result of the second comparator.

(8) The light detection element according to (7), further including:

a plurality of first analog-digital converters arranged in a predetermined direction, each of the first analog-digital converters including the first attenuation circuit, the second attenuation circuit, the first comparator, and the first counter; and
a plurality of second analog-digital converters arranged in the predetermined direction, each of the second analog-digital converters including the third attenuation circuit, the second comparator, and the second counter,
in which one or more of the second analog-digital converters are arranged between the plurality of first analog-digital converters.

(9) The light detection element according to any one of (1) to (6), further including:

a third attenuation circuit that attenuates an input signal at any of a plurality of attenuation rates according to a signal level and outputs an output signal;
a fourth attenuation circuit that attenuates a reference signal at an attenuation rate according to the control signal and outputs an output signal; and
a second comparator that compares the output signal of the third attenuation circuit with the output signal of the fourth attenuation circuit,
in which the second attenuation circuit and the fourth attenuation circuit have different attenuation rates for the reference signal.

(10) The light detection element according to (9), in which
the input signal attenuated by the first attenuation circuit and the input signal attenuated by the third attenuation circuit include pixel signals photoelectrically converted by photoelectric conversion elements having sizes or numbers different from each other.

(11) The light detection element according to any one of (1) to (6), further including

a plurality of analog-digital converters arranged in a predetermined direction, each of the analog-digital converters including the first attenuation circuit, the second attenuation circuit, the first comparator, and the first counter,

in which a plurality of the second attenuation circuits in the plurality of analog-digital converters individually sets an attenuation rate of the reference signal.

(12) A light detection element including:

a first attenuation circuit that attenuates an input signal at any of three or more attenuation rates according to a signal level and outputs an output signal;
a first comparator that compares the output signal of the first attenuation circuit with a reference signal; and
a first counter that generates a digital signal according to the input signal on the basis of a comparison result of the first comparator.

(13) The light detection element according to (12), in which
the first attenuation circuit attenuates and outputs the input signal at any of three or more attenuation rates according to a signal level on the basis of whether or not the signal level of the input signal exceeds a predetermined threshold and a control signal.

(14) The light detection element according to (13), in which
the first attenuation circuit attenuates and outputs at any of two or more attenuation rates according to the signal level of the input signal on the basis of the control signal in a case where the signal level of the input signal exceeds the predetermined threshold, and attenuates and outputs at any of two or more attenuation rates according to the signal level of the input signal on the basis of the control signal in a case where the signal level of the input signal is less than or equal to the predetermined threshold.

(15) The light detection element according to (13) or (14), further including
a logic circuit that generates the control signal according to illuminance of light incident on a target pixel.

(16) The light detection element according to any one of (13) to (15), in which

the input signal includes a reset signal upon photoelectric conversion or a photoelectrically converted pixel signal,
the light detection element further includes a determination section that determines whether or not a signal level of the input signal exceeds the predetermined threshold on the basis of a result of comparison between the pixel signal and the reference signal corresponding to the pixel signal after the first comparator compares the reset signal with the reference signal corresponding to the reset signal, and

the first attenuation circuit selects an attenuation rate on the basis of a determination result of the determination section.

(17) The light detection element according to (16), in which
the determination section compares the pixel signal with the reference signal without attenuating the pixel signal, or compares the pixel signal with the reference signal in a state where the pixel signal is attenuated at an attenuation rate according to the control signal.

(18) The light detection element according to any one of (11) to (17), further including:

a second attenuation circuit that attenuates an input signal at any of three or more attenuation rates according to a signal level and outputs an output signal;
a second comparator that compares the output signal of the second attenuation circuit with a reference signal having a fixed signal level; and
a second counter that generates a digital signal according to the input signal on the basis of a comparison result of the second comparator,
in which the input signal attenuated by the first attenuation circuit and the input signal attenuated by the second attenuation circuit include pixel signals photoelectrically converted by photoelectric conversion elements having sizes or numbers different from each other.

(19) A light detection element including:

a plurality of comparators that compares respective separate input signals with reference signals; and
a plurality of counters that generates digital signals according to corresponding input signals on the basis of comparison results of the plurality of comparators,
in which an attenuation rate of at least one of each of the input signals and each of the reference signals input to each of the plurality of comparators is individually set for each of the plurality of comparators.

(20) The light detection element according to (19), in which

a plurality of first attenuation circuits and a plurality of second attenuation circuits are provided corresponding to the plurality of comparators,
each of the plurality of first attenuation circuits attenuates each of the corresponding input signals at any of three or more attenuation rates according to a signal level and outputs an output signal,

each of the plurality of second attenuation circuits attenuates each of the reference signals at an attenuation rate according to a control signal and outputs an output signal, and

each of the plurality of comparators compares the output signal of the corresponding first attenuation circuit with the output signal of the corresponding second attenuation circuit.

Aspects of the present disclosure are not limited to the above-described individual embodiments, but include various modifications that can be conceived by those skilled in the art, and the effects of the present disclosure are not limited to the above-described contents. That is, various additions, modifications, and partial deletions are possible without departing from the conceptual idea and spirit of the present disclosure derived from the matters defined in the claims and equivalents thereof.

REFERENCE SIGNS LIST

| 1 | Light detection element |
|---|---|
| 2 | Imaging device |
| 3 | Imaging lens |
| 4 | Recording section |
| 5 | Imaging control section |
| 10 | Pixel array section |
| 11 | Vertical scanning circuit |
| 12 | Column ADC |
| 13 | Ramp generation circuit |
| 14 | Logic circuit |
| 15 | Pixel |
| 16 | Transmission buffer |
| 17 | Reception buffer |
| 18 | VSL attenuation circuit |
| 19 | Ramp attenuation circuit |
| 20 | Counter |
| 21 | Photoelectric conversion element |
| 22 | Pixel circuit |
| 23 | Transfer transistor |
| 24 | Floating diffusion (Hereafter referred to as FD) |
| 25 | Reset transistor |
| 26 | Amplification transistor |
| 27 | Selection transistor |
| 31 | Load current supply section |
| 32 | Current source |
| 33 | ADC |
| 33a | First ADC |
| 33b | Second ADC |
| 34 | Signal processing circuit |
| 41 | Comparator |
| 42 | Latch circuit |
| 43 | Multiplexer |
| 44 | Sample and hold circuit |
| 45 | Source follower circuit |

| 46 | Counter |
|---|---|
| 47 | Attenuation rate setting circuit |
| 48 | First series circuit |
| 49 | Second series circuit |
| 50 | Attenuation rate setting circuit |
| 51 | Third series circuit |
| 52 | Fourth series circuit |
| 61 | First series circuit |
| 62 | Second series circuit |
| 63 | Third series circuit |

**Claims**

1. A light detection element comprising:

a first attenuation circuit that attenuates an input signal at any of a plurality of attenuation rates according to a signal level and outputs an output signal;

a second attenuation circuit that attenuates a reference signal at an attenuation rate according to a control signal and outputs an output signal;

a first comparator that compares the output signal of the first attenuation circuit with the output signal of the second attenuation circuit; and

a first counter that generates a digital signal according to the input signal on a basis of a comparison result of the first comparator.

2. The light detection element according to claim 1, wherein
the second attenuation circuit attenuates the reference signal at an attenuation rate according to the control signal and outputs an output signal before the first comparator starts a comparison operation.

3. The light detection element according to claim 1, wherein
the first attenuation circuit determines an attenuation rate according to a signal level of the input signal after an attenuation rate of the second attenuation circuit is determined.

4. The light detection element according to claim 1, further comprising:

a reference signal line that transmits the reference signal; and
a source follower circuit connected to the reference signal line,
wherein the second attenuation circuit includes:

a first switch and a first capacitor connected in series between an output node of the source follower circuit and a first input terminal of the first comparator; and

a second switch and a second capacitor connected in series between the output node of the source follower circuit and the first input terminal of the first comparator, and

the first switch and the second switch are switch-controlled by the control signal.

5. The light detection element according to claim 4, wherein

the second attenuation circuit performs switching control of the first switch and the second switch on a basis of the control signal such that the reference signal is attenuated at an attenuation rate according to a capacitance ratio between the first capacitor and the second capacitor.

6. The light detection element according to claim 5, further comprising

a logic circuit that generates the control signal for performing switching control of the first switch and the second switch according to illuminance of light incident on a target pixel.

7. The light detection element according to claim 1, further comprising:

a third attenuation circuit that attenuates an input signal at any of a plurality of attenuation rates according to a signal level and outputs an output signal;

a second comparator that compares the output signal of the third attenuation circuit with a reference signal having a fixed signal level; and

a second counter that generates a digital signal according to the input signal on a basis of a comparison result of the second comparator.

8. The light detection element according to claim 7, further comprising:

a plurality of first analog-digital converters arranged in a predetermined direction, each of the first analog-digital converters including the first attenuation circuit, the second attenuation circuit, the first comparator, and the first counter; and

a plurality of second analog-digital converters arranged in the predetermined direction, each of the second analog-digital converters including the third attenuation circuit, the second comparator, and the second counter,

wherein one or more of the second analog-digital converters are arranged between the plurality of first analog-digital converters.

9. The light detection element according to claim 1, further comprising:

a third attenuation circuit that attenuates an input signal at any of a plurality of attenuation rates according to a signal level and outputs an output signal;

a fourth attenuation circuit that attenuates a reference signal at an attenuation rate according to the control signal and outputs an output signal; and

a second comparator that compares the output signal of the third attenuation circuit with the output signal of the fourth attenuation circuit, wherein the second attenuation circuit and the fourth attenuation circuit have different attenuation rates for the reference signal.

10. The light detection element according to claim 9, wherein

the input signal attenuated by the first attenuation circuit and the input signal attenuated by the third attenuation circuit include pixel signals photoelectrically converted by photoelectric conversion elements having sizes or numbers different from each other.

11. The light detection element according to claim 1, further comprising

a plurality of analog-digital converters arranged in a predetermined direction, each of the analog-digital converters including the first attenuation circuit, the second attenuation circuit, the first comparator, and the first counter,

wherein a plurality of the second attenuation circuits in the plurality of analog-digital converters individually sets an attenuation rate of the reference signal.

12. A light detection element comprising:

a first attenuation circuit that attenuates an input signal at any of three or more attenuation rates according to a signal level and outputs an output signal;

a first comparator that compares the output signal of the first attenuation circuit with a reference signal; and

a first counter that generates a digital signal according to the input signal on a basis of a comparison result of the first comparator.

13. The light detection element according to claim 12, wherein

the first attenuation circuit attenuates and outputs the input signal at any of three or more attenuation rates according to a signal level on a basis of whether or not the signal level of the input signal exceeds a predetermined threshold and a control signal.

**14.** The light detection element according to claim 13, wherein

the first attenuation circuit attenuates and outputs at any of two or more attenuation rates according to the signal level of the input signal on a basis of the control signal in a case where the signal level of the input signal exceeds the predetermined threshold, and attenuates and outputs at any of two or more attenuation rates according to the signal level of the input signal on a basis of the control signal in a case where the signal level of the input signal is less than or equal to the predetermined threshold.

**15.** The light detection element according to claim 13, further comprising

a logic circuit that generates the control signal according to illuminance of light incident on a target pixel.

**16.** The light detection element according to claim 13, wherein

the input signal includes a reset signal upon photoelectric conversion or a photoelectrically converted pixel signal,

the light detection element further comprises a determination section that determines whether or not a signal level of the input signal exceeds the predetermined threshold on a basis of a result of comparison between the pixel signal and the reference signal corresponding to the pixel signal after the first comparator compares the reset signal with the reference signal corresponding to the reset signal, and

the first attenuation circuit selects an attenuation rate on a basis of a determination result of the determination section.

**17.** The light detection element according to claim 16, wherein

the determination section compares the pixel signal with the reference signal without attenuating the pixel signal, or compares the pixel signal with the reference signal in a state where the pixel signal is attenuated at an attenuation rate according to the control signal.

**18.** The light detection element according to claim 11, further comprising:

a second attenuation circuit that attenuates an input signal at any of three or more attenuation rates according to a signal level and outputs an output signal;

a second comparator that compares the output signal of the second attenuation circuit with a reference signal having a fixed signal level; and

a second counter that generates a digital signal according to the input signal on a basis of a comparison result of the second comparator,

wherein the input signal attenuated by the first attenuation circuit and the input signal attenuated by the second attenuation circuit include pixel signals photoelectrically converted by photoelectric conversion elements having sizes or numbers different from each other.

**19.** A light detection element comprising:

a plurality of comparators that compares respective separate input signals with reference signals; and

a plurality of counters that generates digital signals according to corresponding input signals on a basis of comparison results of the plurality of comparators,

wherein an attenuation rate of at least one of each of the input signals and each of the reference signals input to each of the plurality of comparators is individually set for each of the plurality of comparators.

**20.** The light detection element according to claim 19, wherein

a plurality of first attenuation circuits and a plurality of second attenuation circuits are provided corresponding to the plurality of comparators,

each of the plurality of first attenuation circuits attenuates each of the corresponding input signals at any of three or more attenuation rates according to a signal level and outputs an output signal,

each of the plurality of second attenuation circuits attenuates each of the reference signals at an attenuation rate according to a control signal and outputs an output signal, and

each of the plurality of comparators compares the output signal of the corresponding first attenuation circuit with the output signal of the corresponding second attenuation circuit.

## FIG. 1

2 : IMAGING DEVICE

# FIG. 2

# FIG. 3

# FIG. 4

FIG. 5

12 : COLUMN ADC

# FIG. 6

# FIG. 7

TIME CHART

| R S T | A Z | P– settling | P– count | TRG | | D– settling | D– count |

Lv DETERMINATION

t1 t2 t3　　t4　　　t5　　t6　　t7　　t8　　　t9

VSL (COMPARATOR INPUT Input)

LOW ILLUMINANCE

HIGH ILLUMINANCE

LTOUT (COMPARATOR DETERMINATION RESULT)

HIGH ILLUMINANCE

LOW ILLUMINANCE

VSL ATTENUATION CIRCUIT OUTPUT

LOW ILLUMINANCE

HIGH ILLUMINANCE

RAMP (RAMP WAVEFORM)

WITHOUT ATTENUATION

WITH ATTENUATION

RAMP ATTENUATION CIRCUIT OUTPUT

# FIG. 8

START

ATTENUATE RAMP SIGNAL | S1

INITIALIZE TO RESET LEVEL | S2

AD CONVERSION ON RESET LEVEL | S3

GENERATE PIXEL SIGNAL | S4

PIXEL SIGNAL > THRESHOLD? S5

NO

YES

ATTENUATE PIXEL SIGNAL | S6

COUNTING OPERATION UNTIL PIXEL SIGNAL AND RAMP SIGNAL INTERSECT

S7

COUNTING OPERATION UNTIL PIXEL SIGNAL AND RAMP SIGNAL INTERSECT

S9

MULTIPLY BY RECIPROCAL OF ATTENUATION RATE | S8

HAS AD CONVERSION ON ALL PIXEL ROWS BEEN ENDED? S10

NO

YES

END

FIG. 9A

W5 : RAMP SIGNAL

W1 : VSL (ILLUMINANCE LOW)

W2 : VSL (ILLUMINANCE MEDIUM)

W3 : VSL (ILLUMINANCE LARGE)

W4 : VSL (ILLUMINANCE MAXIMUM)

FIG. 9B

FIG. 10A

W5 : RAMP SIGNAL

W4 : VSL (ILLUMINANCE MAXIMUM)

VSL

EP 4 633 187 A1

# FIG. 10B

VSL

W7

W6

W4：VSL (ILLUMINANCE MAXIMUM)

## FIG. 11A

## FIG. 11B

# FIG. 12A

# FIG. 12B

# FIG. 13

ANALOG GAIN – HORIZONTAL STREAK NOISE

HORIZONTAL STREAK NOISE [uVrms]

ANALOG GAIN [dB]

W21 —●— RAMP-WITHOUT ATT
W22 —◆— RAMP-ATT SETTING 1
W23 —◻— RAMP-ATT SETTING 2
W24 —△— RAMP-ATT SETTING 3

W21

W22

W23

W24

0          6          12          18          24

EP 4 633 187 A1

FIG. 14

12 : COLUMN ADC

FIG. 15

## FIG. 16A

## FIG. 16B

# FIG. 17A

15S
15L

VSL0
VSL1

RAMP

RAMP ATTENUATION CIRCUIT
(FIRST ATTENUATION RATE)

RAMP ATTENUATION CIRCUIT
(SECOND ATTENUATION RATE)

19
19

+  −
+  −

41
41

33(33a)
33(33b)

LARGE PIXEL
SMALL PIXEL

# FIG. 17B

SMALL PIXEL SIGNAL
RAMP FOR SMALL PIXEL

LARGE PIXEL SIGNAL
RAMP FOR LARGE PIXEL

## FIG. 18A

## FIG. 18B

# FIG. 19

FIG. 20

12 : COLUMN ADC

# FIG. 21

RAMP

— FIRST CASE (VSL AMPLITUDE SMALL, WITHOUT ADAPTIVE GAIN)

SECOND CASE (VSL AMPLITUDE LARGE, WITH ADAPTIVE GAIN,
VSL FIRST ATTENUATION RATE)

THIRD CASE (VSL AMPLITUDE LARGE, WITH ADAPTIVE GAIN,
VSL SECOND ATTENUATION RATE)

ADAPTIVE GAIN
DETERMINATION PERIOD

# FIG. 22

RAMP

FOURTH CASE (VSL AMPLITUDE SMALL, WITHOUT ADAPTIVE GAIN,
VSL FIRST ATTENUATION RATE)

FIFTH CASE (VSL AMPLITUDE SMALL, WITHOUT ADAPTIVE GAIN,
VSL SECOND ATTENUATION RATE)

SIXTH CASE (VSL AMPLITUDE LARGE, WITH ADAPTIVE GAIN,
VSL FIRST ATTENUATION RATE)

SEVENTH CASE (VSL AMPLITUDE LARGE, WITH ADAPTIVE GAIN,
VSL SECOND ATTENUATION RATE)

ADAPTIVE GAIN
DETERMINATION PERIOD

FIG. 23

12 : COLUMN ADC

# FIG. 24

# FIG. 25

VSL0

VSL1

~15n

~15z

RAMP ▷

◁ CS21

◁ CS22

VSL ATTENUATION CIRCUIT
(FIRST ATTENUATION RATE)

VSL ATTENUATION CIRCUIT
(SECOND ATTENUATION RATE)

18

18

41

41

33(33a)

33(33b)

NORMAL PIXEL

IMAGE PLANE PHASE
DIFFERENCE PIXEL

# FIG. 26

# FIG. 27

EP 4 633 187 A1

12 : COLUMN ADC

# FIG. 28

# FIG. 29

12 : COLUMN ADC

EP 4 633 187 A1

# FIG. 30

# FIG. 31

15n

15z

VSL0

VSL1

RAMP

CS11

CS12

| VSL ATTENUATION CIRCUIT (FIRST ATTENUATION RATE) | RAMP ATTENUATION CIRCUIT (SECOND ATTENUATION RATE) | VSL ATTENUATION CIRCUIT (THIRD ATTENUATION RATE) | RAMP ATTENUATION CIRCUIT (FOURTH ATTENUATION RATE) | 19 |

18

19

18

CS21

CS22

+ − 41

+ − 41

33(33a)

NORMAL PIXEL

33(33b)

IMAGE PLANE PHASE DIFFERENCE PIXEL

# FIG. 32

## FIG. 33

EP 4 633 187 A1

# FIG. 34

## INTERNATIONAL SEARCH REPORT

| International application No. |
| --- |
| **PCT/JP2023/042647** |

| A. | CLASSIFICATION OF SUBJECT MATTER |
| --- | --- |

*H04N 25/77*(2023.01)i
FI:   H04N25/77

According to International Patent Classification (IPC) or to both national classification and IPC

| B. | FIELDS SEARCHED |
| --- | --- |

Minimum documentation searched (classification system followed by classification symbols)

H04N25/77

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | US 2016/0028981 A1 (SAMSUNG ELECTRONICS CO., LTD.) 28 January 2016 (2016-01-28) | 1-3 |
| | paragraphs [0070], [0079]-[0082], fig. 2, 3 | |
| A | | 4-11, 13-18, 20 |
| X | JP 2018-148541 A (SONY SEMICONDUCTOR SOLUTIONS CORP.) 20 September 2018 (2018-09-20) | 12, 19 |
| | paragraphs [0129]-[0150], fig. 15-18 | |
| A | | 4-11, 13-18, 20 |
| A | JP 2015-231096 A (SONY CORPORATION) 21 December 2015 (2015-12-21) | 1-20 |
| | entire text, all drawings | |
| A | JP 2019-57873 A (SONY SEMICONDUCTOR SOLUTIONS CORP.) 11 April 2019 (2019-04-11) | 1-20 |
| | entire text, all drawings | |

☐ Further documents are listed in the continuation of Box C.     ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **07 February 2024** | **20 February 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2023/042647**

| Patent document cited in search report | | | Publication date (day/month/year) | Patent family member(s) | | | Publication date (day/month/year) |
|---|---|---|---|---|---|---|---|
| US | 2016/0028981 | A1 | 28 January 2016 | KR 10-2016-0012802 | A | | |
| JP | 2018-148541 | A | 20 September 2018 | US 2020/0053308 paragraphs [0169]-[0191], fig. 15-18 | A1 | | |
| | | | | WO 2018/159343 | A1 | | |
| | | | | EP 4120675 | A1 | | |
| | | | | CN 110291785 | A | | |
| | | | | KR 10-2019-0120221 | A | | |
| JP | 2015-231096 | A | 21 December 2015 | WO 2015/186533 entire text, all drawings | A1 | | |
| JP | 2019-57873 | A | 11 April 2019 | US 2020/0260034 entire text, all drawings | A1 | | |
| | | | | WO 2019/058959 | A1 | | |
| | | | | CN 111095917 | A | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019057873 A